(19) Europäisches Patentamt
European Patent Office
Office européen des brevets

(11) **EP 4 280 162 A1**

(12) **EUROPEAN PATENT APPLICATION**

(43) Date of publication:
**22.11.2023 Bulletin 2023/47**

(21) Application number: **23163459.3**

(22) Date of filing: **22.03.2023**

(51) International Patent Classification (IPC):
**G06T 17/10** (2006.01)    **G06F 30/10** (2020.01)

(52) Cooperative Patent Classification (CPC):
**G06T 17/10; G06F 30/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.05.2022 US 202217747953**

(71) Applicant: **Autodesk, Inc.**
**San Francisco, CA 94105 (US)**

(72) Inventor: **LAMBOURNE, Joseph George**
**San Francisco, 94105 (US)**

(74) Representative: **Fish & Richardson P.C.**
**Highlight Business Towers**
**Mies-van-der-Rohe-Straße 8**
**80807 München (DE)**

(54) **GENERATING PRISMATIC CAD MODELS BY MACHINE LEARNING**

(57)     Methods, systems, and apparatus, including medium-encoded computer program products, for computer aided design and manufacture of physical structures by generating prismatic CAD models using machine learning, include: obtaining an input embedding that encodes a representation of a target two-dimensional (2D) shape; processing the input embedding using a 2D decoder of a 2D autoencoder to obtain a decoded representation of the target 2D shape; determining a fitted 2D parametric sketch model for the input embedding, including: finding a 2D parametric sketch model for the input embedding using a search in an embedding space of the 2D autoencoder and a database of sketch models associated with the 2D autoencoder, and fitting the 2D parametric sketch model to the decoded representation of the target 2D shape; and using the fitted 2D parametric sketch model in a computer modeling program.

FIG. 1

EP 4 280 162 A1

**Description**

BACKGROUND

This specification relates to computer aided design and manufacture of physical structures.

Computer Aided Design (CAD) software has been developed and used to generate three-dimensional (3D) representations of objects, and Computer Aided Manufacturing (CAM) software has been developed and used to manufacture the physical structures of those objects, e.g., using Computer Numerical Control (CNC) manufacturing techniques. Typically, CAD software stores the 3D representations of the geometry of the objects being modeled using a boundary representation (B-Rep) format. A B-Rep model is a set of connected surface elements specifying boundaries between a solid portion and a non-solid portion of the modeled 3D object. In a B-Rep model (often referred to as a B-Rep), geometry is stored in the computer using smooth and precise mathematical surfaces, in contrast to the discrete and approximate surfaces of a mesh model, which can be difficult to work with in a CAD program.

Further, CAD software has been designed so as to perform a generative design process, e.g., automatic generation of 3D geometry for a part or one or more parts in a larger system of parts to be manufactured. This automated generation of 3D geometry is often limited to a design space specified by a user of the CAD software, and the 3D geometry generation is typically governed by design objectives and constraints, which can be defined by the user of the CAD software or by another party and imported into the CAD software. The design objectives (such as minimizing the waste material or weight of the designed part) can be used to drive the geometry generation process toward better designs. The design constraints can include both structural integrity constraints for individual parts (i.e., a requirement that a part should not fail under the expected structural loading during use of the part) and physical constraints imposed by a larger system (i.e., a requirement that a part not interfere with another part in a system during use).

However, the 3D models generated directly from the generative design process may not be suitable for manufacturing. For example, models from generative design may have rounded edges and may have shapes that are different from sketch models designed by humans. Often, users of the CAD software are required to manually adjust the 3D models to generate modified 3D models that are suitable for manufacturing.

SUMMARY

This specification describes technologies relating to computer aided design of physical structures by generating prismatic CAD models using machine learning.

In general, one or more aspects of the subject matter described in this specification can be embodied in one or more methods (and also one or more non-transitory computer-readable mediums tangibly encoding a computer program operable to cause data processing apparatus to perform operations) including: obtaining an input embedding that encodes a representation of a target two-dimensional (2D) shape; processing the input embedding using a 2D decoder of a 2D autoencoder to obtain a decoded representation of the target 2D shape, wherein the 2D autoencoder includes a 2D encoder that processes a representation of a 2D object to generate an object embedding, and the 2D decoder that processes the object embedding to generate the decoded representation of the 2D object; determining a fitted 2D parametric sketch model for the input embedding, including: finding a 2D parametric sketch model for the input embedding using a search in an embedding space of the 2D autoencoder and a database of sketch models associated with the 2D autoencoder, wherein a shape of the 2D parametric sketch model is determined by one or more parameter values of the 2D parametric sketch model; and fitting the 2D parametric sketch model to the decoded representation of the target 2D shape by modifying the one or more parameter values of the 2D parametric sketch model to produce the fitted 2D parametric sketch model; and using the fitted 2D parametric sketch model in a computer modeling program.

The method (or operations performed by the data processing apparatus in accordance with the computer program tangibly encoded in one or more non-transitory computer-readable mediums) can include: obtaining parameterized instantiations of 2D parametric sketch models; generating 2D training images from the parameterized instantiations of the 2D parametric sketch models, wherein each of the 2D training images corresponds to a parameterized instantiation of a 2D parametric sketch model; and training the 2D autoencoder on the 2D training images, including: for each of the 2D training images: processing the 2D training image using the 2D encoder to generate an embedding; and processing the embedding using the 2D decoder to generate a decoded 2D image; computing a value of a loss function by comparing each of the 2D training images with its corresponding decoded 2D image; and updating parameters of the 2D encoder and parameters of the 2D decoder based on the value of the loss function. Training the 2D autoencoder on the 2D training images can include: generating a signed distance field image from the 2D training image; and processing the signed distance field image using the 2D encoder to generate the embedding.

The method (or operations performed by the data processing apparatus in accordance with the computer program tangibly encoded in one or more non-transitory computer-readable mediums) can include: obtaining an initial input embedding that encodes a representation of a target three-dimensional (3D) object; processing the initial input embedding using a sub-embedding decoder of a 3D autoencoder to obtain sub-embeddings including the input embedding, wherein the sub-embeddings encode 2D shapes that define the representation of the target 3D object; generating parametric sketch models, including: processing each of the sub-embeddings using one or more intermediate 2D decoders to obtain the 2D shapes that define the representation of the target 3D object; generating each of intermediate embeddings by processing each of the 2D shapes using the 2D encoder of the 2D autoencoder; and performing the determining a respective parametric sketch model of the parametric sketch models for each of the intermediate embeddings, wherein the respective parametric sketch model is the fitted 2D parametric sketch model, wherein the decoded representation of the target 2D shape is each of the 2D shapes; generating a set of extrusion parameters from the sub-embeddings; and generating a 3D boundary representation (B-Rep) model of the target 3D object, wherein the generating includes using the fitted 2D parametric sketch models in a construction sequence to construct the 3D B-Rep model through extrusion into a 3D space, wherein the construction sequence includes the set of extrusion parameters.

The sub-embedding decoder can include a multi-layer perceptron (MI,P). The one or more intermediate 2D decoders can include the 2D decoder of the 2D autoencoder. The one or more intermediate 2D decoders can include a second 2D decoder that is different from the 2D decoder of the 2D autoencoder. The 3D autoencoder can include: a 3D encoder that processes an input voxel model to generate a 3D object embedding, the sub-embedding decoder that processes the 3D object embedding to generate the sub-embeddings, a start envelope decoder that processes each sub-embedding of the sub-embeddings to generate a start envelope function, an end envelope decoder that processes each sub-embedding of the sub-embeddings to generate an end envelope function, wherein the set of extrusion parameters are generated from the start envelope function and the end envelope function, and a differentiable Boolean engine that generates a reconstructed model by extruding the 2D shapes into the 3D space using the start envelope function and the end envelope functions.

The method (or operations performed by the data processing apparatus in accordance with the computer program tangibly encoded in one or more non-transitory computer-readable mediums) can include obtaining training examples, wherein each training example includes a training voxel model, a ground truth voxel model, and ground truth 2D shapes, wherein the ground truth voxel model is defined by the ground truth 2D shapes extruded into a 3D space using a set of ground truth extrusion parameters that defines a ground truth envelope function, wherein the training voxel model is generated from the ground truth voxel model; and training the 3D autoencoder on the training examples, including: for each of the training examples: processing the training voxel model using the 3D encoder to generate the 3D object embedding of the training voxel model; and processing the 3D object embedding using the sub-embedding decoder to generate the sub-embeddings; processing each sub-embedding of the sub-embeddings using the 2D decoder to generate a 2D shape of the 2D shapes; processing each sub-embedding of the sub-embeddings using the start envelope decoder to generate a start envelope function of the 2D shape; processing each sub-embedding of the sub-embeddings using the end envelope decoder to generate an end envelope function of the 2D shape; and generating a reconstructed voxel model of the training voxel model by using the 2D shapes in a predicted construction sequence to construct the reconstructed voxel model through expansion in the 3D space, wherein the predicted construction sequence includes operations defined in the differentiable Boolean engine and the start envelope function and the end envelope function of each of the 2D shapes; computing a value of a first loss function by comparing each training voxel model with its corresponding reconstructed voxel model; and updating parameters of the 3D autoencoder based at least on the value of the first loss function.

The method (or operations performed by the data processing apparatus in accordance with the computer program tangibly encoded in one or more non-transitory computer-readable mediums) can include: computing a value of a second loss function by comparing the ground truth 2D shapes with the 2D shapes and by comparing the start envelope function and the end envelope function with the ground truth envelope function; and updating the parameters of the 3D autoencoder based at least on the value of the first loss function and the value of the second loss function. The training voxel model can be generated from the ground truth voxel model through a morphological modification. The 3D autoencoder can include decoding modules and each of the decoding modules corresponds to a different predefined set of one or more extrusion directions and a different predefined one or more Boolean operations, wherein each of the decoding modules can include a respective sub-embedding decoder, a respective start envelope decoder, and a respective end envelope decoder. Obtaining the initial input embedding can include: generating a first 3D object embedding from a first voxel model of a first 3D object; generating a second 3D object embedding from a second voxel model of a second 3D object; and generating the initial input embedding from the first 3D object embedding and the second 3D object embedding.

The method (or operations performed by the data processing apparatus in accordance with the computer program tangibly encoded in one or more non-transitory computer-readable mediums) can include: obtaining an initial voxel model of the target 3D object; generating a modified voxel model by processing the initial voxel model through a morphological modification; generating the initial input embedding by processing the modified voxel model using a 3D encoder included in the 3D autoencoder; and generating a reconstructed 3D B-Rep model from the fitted 2D parametric sketch models using the construction sequence through the extrusion into the 3D space, wherein the reconstructed 3D B-Rep model is similar to the initial voxel model.

The method (or operations performed by the data processing apparatus in accordance with the computer program tangibly encoded in one or more non-transitory computer-readable mediums) can include: obtaining an initial voxel model of the target 3D object, wherein the initial voxel model is generated from a generative design output; generating the initial input embedding by processing the initial voxel model using a 3D encoder included in the 3D autoencoder; and generating a 3D prismatic model of the target 3D object, wherein the 3D prismatic model of the target 3D object is the 3D B-Rep model.

The method (or operations performed by the data processing apparatus in accordance with the computer program tangibly encoded in one or more non-transitory computer-readable mediums) can further include: obtaining an initial voxel model of the target 3D object, wherein the initial voxel model is generated from a generative design output; generating the initial input embedding by processing the initial voxel model using a 3D encoder included in the 3D autoencoder; and fitting the 3D B-Rep model to the initial voxel model of the target 3D object by changing one or more parameters of the 3D B-Rep model to produce a fitted 3D B-Rep model. The using the fitted 2D parametric sketch model can include: displaying the fitted 2D parametric sketch model in a user interface of the computer modeling program.

The method (or operations performed by the data processing apparatus in accordance with the computer program tangibly encoded in one or more non-transitory computer-readable mediums) can include: obtaining an input 2D image, wherein the input 2D image includes two or more 2D shapes; generating sub-image portions from the input 2D image, wherein each sub-image portion depicts a 2D shape of the two or more 2D shapes; generating a respective sub-image portion embedding for each sub-image portion of the sub-image portions; determining fitted 2D parametric sketch models, including: performing the determining each fitted 2D parametric sketch model for each sub-image portion embedding; and generating a combined 2D parametric sketch model by combining the fitted 2D parametric sketch models at respective locations of the sub-image portions.

One or more aspects of the subject matter described in this specification can also be embodied in one or more systems including: a non-transitory storage medium having instructions of a computer aided design program stored thereon; and one or more data processing apparatus configured to run the instructions of the computer aided design program to perform operations specified by the instructions of the computer aided design program; wherein the operations include: obtaining an input embedding that encodes a representation of a target two-dimensional (2D) shape; processing the input embedding using a 2D decoder of a 2D autoencoder to obtain a decoded representation of the target 2D shape, wherein the 2D autoencoder includes a 2D encoder that processes a representation of a 2D object to generate an object embedding, and the 2D decoder that processes the object embedding to generate the decoded representation of the 2D object; determining a fitted 2D parametric sketch model for the input embedding, including: finding a 2D parametric sketch model for the input embedding using a search in an embedding space of the 2D autoencoder and a database of sketch models associated with the 2D autoencoder, wherein a shape of the 2D parametric sketch model is determined by one or more parameter values of the 2D parametric sketch model; and fitting the 2D parametric sketch model to the decoded representation of the target 2D shape by modifying the one or more parameter values of the 2D parametric sketch model to produce the fitted 2D parametric sketch model; and using the fitted 2D parametric sketch model in a computer modeling program.

The operations can include: obtaining parameterized instantiations of 2D parametric sketch models; generating 2D training images from the parameterized instantiations of the 2D parametric sketch models, wherein each of the 2D training images corresponds to a parameterized instantiation of a 2D parametric sketch model; and training the 2D autoencoder on the 2D training images, including: for each of the 2D training images: processing the 2D training image using the 2D encoder to generate an embedding; and processing the embedding using the 2D decoder to generate a decoded 2D image; computing a value of a loss function by comparing each of the 2D training images with its corresponding decoded 2D image; and updating parameters of the 2D encoder and parameters of the 2D decoder based on the value of the loss function.

The operations can include: obtaining an initial input embedding that encodes a representation of a target three-dimensional (3D) object; processing the initial input embedding using a sub-embedding decoder of a 3D autoencoder to obtain sub-embeddings including the input embedding, wherein the sub-embeddings encode 2D shapes that define the representation of the target 3D object; generating parametric sketch models, including: processing each of the sub-embeddings using one or more intermediate 2D decoders to obtain the 2D shapes that define the representation of the target 3D object; generating each of intermediate embeddings by processing each of the 2D shapes using the 2D encoder of the 2D autoencoder; and performing the determining a respective parametric sketch model of the parametric sketch models for each of the intermediate embeddings, wherein the respective parametric sketch model is the fitted 2D parametric sketch model, wherein the decoded representation of the target 2D shape is each of the 2D shapes; generating a set of extrusion parameters from the sub-embeddings; and generating a 3D boundary representation (B-Rep) model of the target 3D object, wherein the generating includes using the fitted 2D parametric sketch models in a construction sequence to construct the 3D B-Rep model through extrusion into a 3D space, wherein the construction sequence includes the set of extrusion parameters.

The 3D autoencoder can include: a 3D encoder that processes an input voxel model to generate a 3D object embedding, the sub-embedding decoder that processes the 3D object embedding to generate the sub-embeddings, a start envelope decoder that processes each sub-embedding of the sub-embeddings to generate a start envelope function, an end envelope decoder that processes each sub-embedding of the sub-embeddings to generate an end envelope function, wherein the set of extrusion parameters are generated from the start envelope function and the end envelope function, and a differentiable Boolean engine that generates a reconstructed model by extruding the 2D shapes into the 3D space using the start envelope function and the end envelope functions.

The operations can include: obtaining training examples, wherein each training example includes a training voxel model, a ground truth voxel model, and ground truth 2D shapes, wherein the ground truth voxel model is defined by the ground truth 2D shapes extruded into a 3D space using a set of ground truth extrusion parameters that defines a ground truth envelope function, wherein the training voxel model is generated from the ground truth voxel model; and training the 3D autoencoder on the training examples, including: for each of the training examples: processing the training voxel model using the 3D encoder to generate the 3D object embedding of the training voxel model; and processing the 3D object embedding using the sub-embedding decoder to generate the sub-embeddings; processing each sub-embedding of the sub-embeddings using the 2D decoder to generate a 2D shape of the 2D shapes; processing each sub-embedding of the sub-embeddings using the start envelope decoder to generate a start envelope function of the 2D shape; processing each sub-embedding of the sub-embeddings using the end envelope decoder to generate an end envelope function of the 2D shape; and generating a reconstructed voxel model of the training voxel model by using the 2D shapes in a predicted construction sequence to construct the reconstructed voxel model through expansion in the 3D space, wherein the predicted construction sequence includes operations defined in the differentiable Boolean engine and the start envelope function and the end envelope function of each of the 2D shapes; computing a value of a first loss function by comparing each training voxel model with its corresponding reconstructed voxel model; and updating parameters of the 3D autoencoder based at least on the value of the first loss function.

Particular embodiments of the subject matter described in this specification can be implemented to realize one or more of the following advantages. A machine learning model, such as a decoder of an autoencoder, can take embedding vectors as input and can generate prismatic boundary representation (B-Rep) models of a target 3D object without a need for providing the target geometry and the prismatic models can be easier to manufacture than other types of models, e.g., voxel models. A machine learning model can rebuild 3D models from approximate data, such as point clouds or meshes. A machine learning model can generate a 3D model that is an interpolation between existing models. A machine learning model can perform style transfer, e.g., transferring local details between existing models. In some cases, a 3D prismatic B-Rep model that looks like a human designed geometry can be automatically generated by the machine learning model(s) from an output of a generative design or a topology optimization process, which can reduce the time needed to manually adjusting the 3D model to obtain a model that is suitable for manufacturing. In some cases, the machine learning model(s) can automatically generate a 3D model in which a design criteria is specified for only one or more parts, and the design of the whole 3D model is unspecified or unknown. For example, the machine learning model(s) can be used to create parts based on some approximate shapes.

The 3D model generated by the machine learning model(s) is editable because the 3D model is generated with constrained sketches and an editable parametric feature history. Generating prismatic models as CAD construction sequences (e.g., a sequence of steps that are used to generate a CAD model) can be highly non-linear or irregular because very similar CAD sequences can generate very different shapes and very different CAD sequences can generate almost identical shapes. Rather than encoding in a sequence space, the machine learning model can process an input embedding vector that encodes a voxel representation of a target 3D object in an embedding space of an autoencoder. Because similar shapes in the voxel representation can have similar embeddings generated by an encoder of an autoencoder, a change in the embedding space of the autoencoder can result in a proportional and continuous change in the corresponding output 3D shape. Thus, a small change in the embedding vector can correspond to a small change in the shape of the 3D model, improving the reliability and predictability of the generated 3D model. In some implementations, a complex shape can be split into smaller portions in the image space and fitted parametric sketch models can be searched for each smaller portion.

One or more machine learning models can be trained with a first loss function that supervises the predicted 3D voxel model and a second loss function that supervises the 2D shapes (profiles) that are used to construct the predicted 3D voxel model. By using the supervisions in both 3D and 2D during the training, the machine learning model(s) can automatically generate 3D models that have desirable features (e.g., 2D profiles or shapes which can be useful for CAD extrusions) without requiring knowledge of the sequence of profiles and envelope functions. The machine learning function can be trained to process an embedding of a signed distance field image generated using a signed distance function. Thus, the machine learning function can generate more desirable 2D or 3D models because the signed distance field image can provide an improved description of the 2D or 3D shape.

The details of one or more embodiments of the subject matter described in this specification are set forth in the accompanying drawings and the description below. Other features, aspects, and advantages of the invention will become apparent from the description, the drawings, and the embodiments.

BRIEF DESCRIPTION OF THE DRAWINGS

FIG. 1 shows an example of a system usable to design and manufacture physical structures.
FIG. 2A shows an example of a process to generate a 3D model of a target 3D object by a machine learning algorithm.
FIG. 2B is a flowchart showing an example of a process to generate a 3D model of a target 3D object by a machine learning algorithm.
FIG. 3 is a flowchart and corresponding system operations diagram showing an example of a process to generate a fitted 2D parametric sketch model of a target 2D shape by a machine learning algorithm.
FIG. 4 is a flowchart and corresponding system operations diagram showing an example of a process to train a 2D autoencoder that can be used to determine a fitted 2D parametric sketch model of a target 2D shape.
FIG. 5 shows an example of a process to train a 3D autoencoder that can be used to generate a 3D model of a target 3D object.
FIG. 6 is a flowchart showing an example of a process to train a 3D autoencoder that can be used to generate a 3D model of a target 3D object.
FIG. 7 shows an example of a neural network architecture for a 3D autoencoder that can be used to generate a 3D model of a target 3D object.
FIG. 8A shows an example of a process to determine fitted 2D parametric sketch models for a complex 2D shape.
FIG. 8B shows an example of a process to generate sub-image portions from an input 2D image.
FIG. 9 is a schematic diagram of a data processing system usable to implement the described systems and techniques.

Like reference numbers and designations in the various drawings indicate like elements.

DETAILED DESCRIPTION

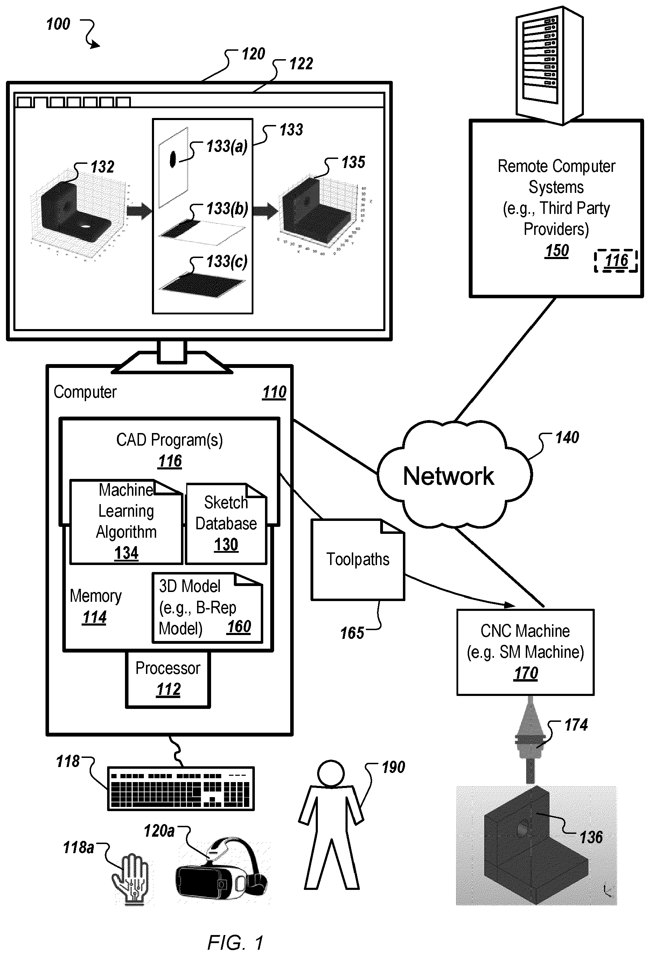

FIG. 1 shows an example of a system 100 usable to design and manufacture physical structures. A computer 110 includes a processor 112 and a memory 114, and the computer 110 can be connected to a network 140, which can be a private network, a public network, a virtual private network, etc. The processor 112 can be one or more hardware processors, which can each include multiple processor cores. The memory 114 can include both volatile and non-volatile memory, such as Random Access Memory (RAM) and Flash RAM. The computer 110 can include various types of computer storage media and devices, which can include the memory 114, to store instructions of programs that run on the processor 112.

Such programs include one or more 3D modeling, simulation and/or manufacturing control programs, such as Computer Aided Design (CAD) program(s) 116. The program(s) 116 can run locally on computer 110, remotely on a computer of one or more remote computer systems 150 (e.g., one or more third party providers' one or more server systems accessible by the computer 110 via the network 140) or both locally and remotely. A machine learning algorithm 134 can be stored in the memory 114 (and/or in the one or more remote computer systems 150) and can be accessed by the CAD program(s) 116.

The CAD program(s) 116 presents a user interface (UI) 122 on a display device 120 of the computer 110, which can be operated using one or more input devices 118 of the computer 110 (e.g., keyboard and mouse). Note that while shown as separate devices in FIG. 1, the display device 120 and/or input devices 118 can also be integrated with each other and/or with the computer 110, such as in a tablet computer or in virtual reality (VR) or augmented reality (AR) system. For example, the input/output devices 118, 120 can include a VR input glove 118a and a VR headset 120a.

A user 190 can interact with the program(s) 116 to create and/or load a representation 132 of a target 3D object 136. An exact voxel model of the target 3D object 136 is unknown, and only an idea or a portion of the target 3D object 136 is known. The representation 132 can be a result of an initial design (e.g., a blobby or fuzzy 3D voxel model) of the target 3D object 136 generated from a generative design process. In some implementations not shown in FIG. 1, the representation 132 can be a 2D image of the target 3D object 136. In some cases, the representation 132 can be encoded using a 3D encoder to generate an embedding, e.g., an embedding vector or an embedding matrix, that encodes the representation of the target 3D object. For example, the representation 132 can be a result of interpolation between two embeddings of two known shapes when the target 3D object is a shape that is in between the two known shapes.

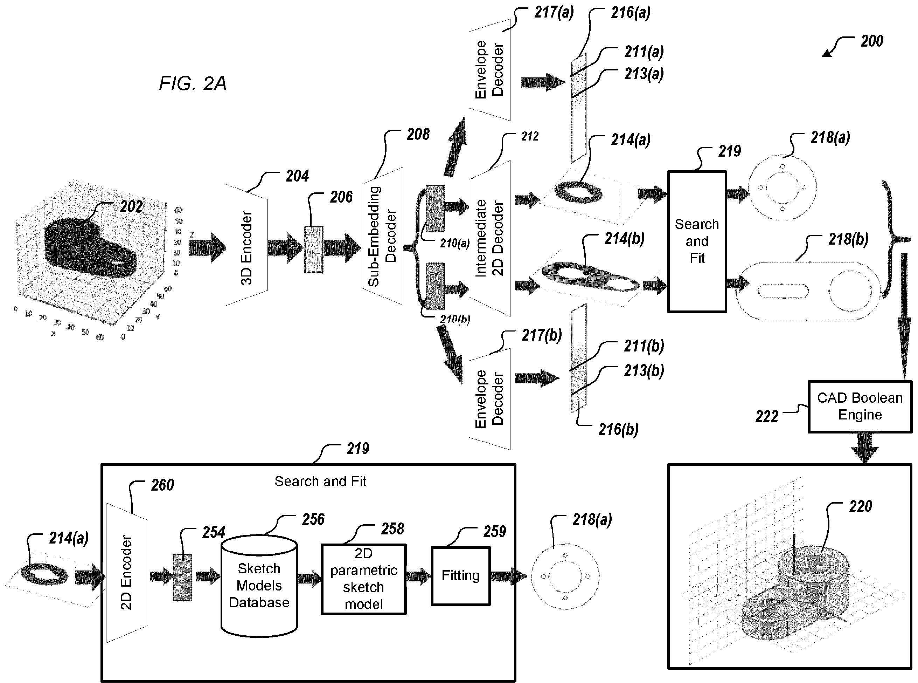

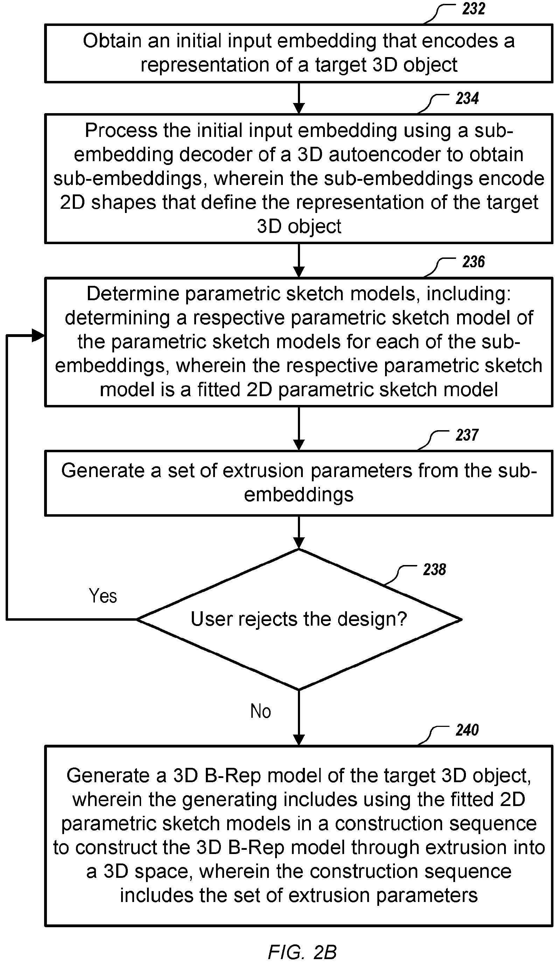

The CAD program(s) 116 can use the machine learning algorithm 134 to generate a 3D model 135 (e.g., a 3D B-Rep model) of the target 3D object 136 from the representation 132 of the target 3D object 136. The machine learning algorithm 134 can automatically decode the representation 132 to generate 2D shapes or profiles that are fitted 2D parametric sketch models 133, including the 2D shapes 133(a), 133(b), and 133(c). The fitted 2D parametric sketch models 133 can be obtained by performing a search in a database 130 of sketch models, which can be local to the computer 110 (as shown) or part of a remote computer system 150. The CAD program(s) 116 can automatically generate a 3D model 135, e.g., a 3D B-Rep model, of the target 3D object 136 using the fitted 2D parametric sketch models 133 in a construction sequence through extrusion into a 3D space. The automatic process of decoding the representation 132 and generating the 3D model 135 can accelerate the 3D model generation process and the generated 3D model 135 can be readily suitable for manufacturing by a CNC machine 170. Therefore, the automatic process can reduce the time needed to produce a manufacturable structure and likewise reduce the time needed to go from conception of new parts to the actual manufacture of those new parts. Details of decoding the representation to generate the fitted 2D parametric sketch models are described below in connection with FIG. 2A and FIG. 2B.

The program(s) 116 can include in the UI 122 a series of menus that allows the user 190 to accept or reject one or more 3D models 135 automatically generated by the machine learning algorithm 134. In some implementations, the program(s) 116 can include in the UI 122 a series of menus that allows the user 190 to adjust one or more portions of a 3D model 135 until a user is satisfied with the 3D model. Once the user 190 accepts the 3D model generated by the machine learning algorithm, the program(s) 116 can save the 3D model in a 3D model document 160. In addition, the user 190 can interact with the program(s) 116 to make additional modifications to the 3D model 135 before it is saved in the 3D model document 160. For example, fillets can be fitted based on 3D model 135.

The 3D model 135 generated by the machine learning algorithm of the CAD program(s) 116 can be used by a computer-controlled manufacturing system, e.g., by a CNC machine 170, such as a subtractive manufacturing (SM) machine, etc., to manufacture the target 3D object 136. This can be done using known graphical user interface tools. The 3D model 135 can be defined in the computer using various known 3D modeling formats, such as using solid models (e.g., voxels) or surface models (e.g., B-Rep, surface meshes).

Once the 3D model 135 of the target 3D object 136 is ready for manufacturing, the 3D model 135 can be prepared for manufacturing the physical structure of the object 136 by generating toolpaths for use by the computer-controlled manufacturing system to manufacture the target 3D object 136. For example, the 3D model 135 can be used to generate a toolpath specification document 165, which can be sent to the CNC machine 170 and used to control operation of one or more milling tools. This can be done upon request by the user 190, or in light of the user's request for another action, such as sending the 3D model document 160 to the CNC machine 170, or other manufacturing machinery, which can be directly connected to the computer 110, or connected via a network 140, as shown. This can involve a post-processing step carried out on the local computer 110 or a cloud service to export the 3D model document 160 to an electronic document from which to manufacture. Note that an electronic document (which for brevity will simply be referred to as a document) can be a file, but does not necessarily correspond to a file. A document can be stored in a portion of a file that holds other documents, in a single file dedicated to the document in question, or in multiple coordinated files.

In any case, the program(s) 116 can create one or more toolpaths in the document 165 and provide the document 165 (of an appropriate format) to the CNC machine 170 to create the physical structure of the target 3D object 136 (note that in some implementations, the computer 110 is integrated into the CNC machine 170, and so the toolpath specification document 165 is created by the same computer that will use the toolpath specification document 165 to manufacture the object 136). For example, the CNC machine 170 can be a subtractive manufacturing machine that can manufacture the object 180 by removing stock material. The CNC machine 170 can use the toolpaths (e.g., saved in the document 165) to control the cutting tool 174.

While the example above focuses on subtractive manufacturing, various other manufacturing systems and processes can be used, including additive manufacturing (AM) as well as hybrid AM + SM manufacturing. Moreover, the systems and techniques described in this application can also be used with 3D modeling programs 116 that support building construction management or video and movie production. For example, the interpolation between existing models, as described in this application, can be used to generate a new 3D character (in a video/movie production workflow) that is a blend of two existing 3D characters. Other applications are also possible. The systems and techniques described in this application can also be used with other forms of representations of a target 3D object. For example, the input to the system can include a point cloud representing a target 3D object and the machine learning algorithm 134 can include a PointNet neural network (Qi, Charles R., et al. "Pointnet: Deep learning on point sets for 3d classification and segmentation. " Proceedings of the IEEE conference on computer vision and pattern recognition. 2017) that can be trained to process point cloud data. For example, the input to the system can include a natural language text that can be decoded with a pretrained natural language processing machine learning model. In some implementations, the input to the system can include both the voxel representation 132 and a second representation, e.g., a 2D image, a point cloud, a text, etc.

FIG. 2A shows an example of a process 200 to generate a 3D model of a target 3D object by a machine learning algorithm. FIG. 2B is a flowchart showing an example of a process to generate a 3D model of a target 3D object by a machine learning algorithm. An initial input embedding that encodes a representation of a target 3D object is obtained 232, by the program(s) 116. Referring to FIG. 2A, an initial input embedding 206 is obtained, by the program(s) 116. The initial input embedding 206 can be an output from a 3D encoder 204 that encodes an initial design, e.g., an initial 3D voxel model 202 of the target 3D object. The initial input embedding 206 can be a one-dimensional vector with floating point numbers or other types of numeric values, e.g., a vector with a length 512, 1024, or 2048 bits, bytes, words, or double words of integer values. In some implementations, the initial input embedding 206 can be an embedding matrix. In some implementations, the initial input embedding 206 can be an arbitrary embedding vector or matrix that corresponds to an unknown 3D shape.

An embedding, as used in this specification, is a numeric representation of features of an image or features of a 3D voxel model of the target 3D object. In particular, an embedding is a numeric representation in an embedding space, i.e., an ordered collection of a fixed number of numeric values, where the number of numeric values is equal to the dimensionality of the embedding space. The embedding space can be a high dimensional space and embeddings can be points in the high dimensional space. For example, the embedding can be a vector of floating point or other types of numeric values. Generally, the dimensionality of the embedding space is much smaller than the number of numeric values in an image or a voxel model represented by a given embedding. A search can be performed using a query embedding to find another embedding that is close to a query embedding in the embedding space because similar shapes can have similar embeddings (e.g., embedding vectors) in the embedding space.

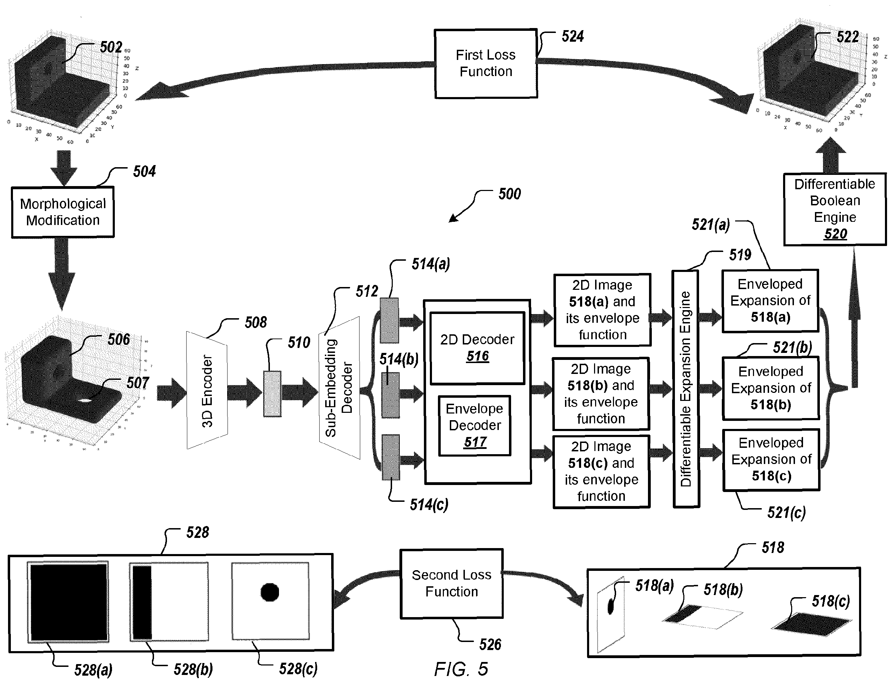

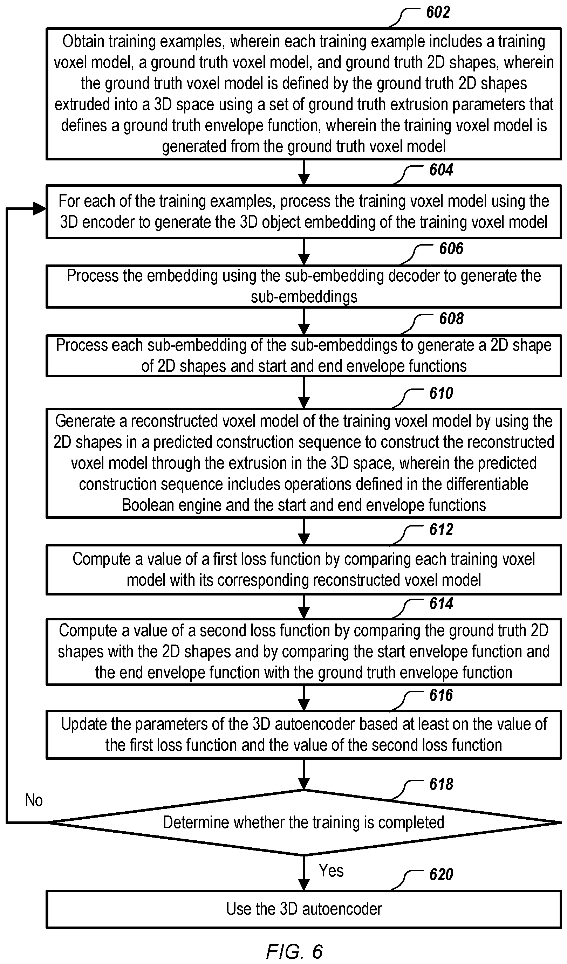

The 3D encoder 204 belongs to a 3D autoencoder. The 3D autoencoder includes a 3D encoder 204 and a sub-embedding decoder 208. The 3D autoencoder can be trained to encode a 3D voxel model into an embedding and to decode the embedding into 2D profiles that can be used to reconstruct the 3D voxel model in a construction sequence (e.g., a parametric construction sequence). Details of training the 3D autoencoder are described below in connection with FIG. 5 and FIG. 6. The 3D encoder can include a 3D convolutional neural network (CNN) including one or more 3D convolutional layers with configurable sizes, one or more fully connected layers, one or more activation layers, or skip connections between the layers, etc. The sub-embedding decoder can include a CNN including one or more fully connected layers, one or more activation layers, or skip connections between the layers, etc. In some implementations, the sub-embedding decoder can include a multi-layer perceptron (MLP) that includes a series of multi-layer perceptron network layers.

In some implementations, the initial input embedding 206 can be generated from two embeddings of two 3D objects when the target 3D object is some shape in between the two 3D objects. The program(s) 116 can generate a first 3D object embedding from a first voxel model of the first 3D object. The program(s) 116 can generate a second 3D object embedding from a second voxel model of the second 3D object. The program(s) 116 can generate the initial input embedding 206 from the first 3D object embedding and the second 3D object embedding, e.g., by interpolating the first 3D object embedding and the second 3D object embedding.

Referring again to FIG. 2B, the initial input embedding is processed 234, by the program(s) 116, using the sub-embedding decoder of the 3D autoencoder to obtain sub-embeddings, and the sub-embeddings encode 2D shapes that define the representation of the target 3D object. Referring to FIG. 2A, the sub-embedding decoder 208 receives the initial input embedding 206 as input. The sub-embedding decoder 208 can process the initial input embedding 206 to generate sub-embeddings 210(a) and 210(b). The sub-embeddings can represent a set of 2D shapes, e.g., the shapes 214(a) and 214(b), that define the representation of the target 3D object. In some implementations, each sub-embedding encodes a respective 2D shape that is at a predetermined 2D orientation. For example, the sub-embedding 210(a) encodes a 2D shape 214(a) in the x-y plane and the sub-embedding 210(b) encodes a 2D shape 214(b) in the x-y plane.

Referring again to FIG. 2B, parametric sketch models are determined 236, by the program(s) 116. The program(s) 116 determines a respective parametric sketch model for each of the sub-embeddings. The respective parametric sketch model for each of the sub-embeddings is a fitted 2D parametric sketch model. A 2D parametric sketch model is a 2D model of a 2D shape. The shape of a 2D parametric sketch model can be determined by one or more parameter values of the 2D parametric sketch model. Because modeling a 3D object as sketches can be difficult, a 2D portion of a 3D object can be modeled as a 2D parametric sketch model that can be extruded into a 3D space. In some implementations, the program(s) 116 processes each of the sub-embeddings using one or more intermediate 2D decoders to obtain 2D shapes that define the representation of the target 3D object. The program(s) 116 generates each of intermediate embeddings by processing each of the 2D shapes using a 2D encoder of a 2D autoencoder. The program(s) 116 determines a respective fitted 2D parametric sketch model for each of the intermediate embeddings.

Referring to FIG. 2A, a fitted 2D parametric sketch model can be determined for each sub-embedding. For example, a fitted 2D parametric sketch model 218(a) can be determined for the sub-embedding 210(a), and a fitted 2D parametric sketch model 218(b) can be determined for the sub-embedding 210(b). A trained intermediate 2D decoder 212 takes the sub-embedding 210(a) or 210(b) as input and generates a decoded 2D shape 214(a) or 214(b). The program(s) 116 performs a search and fit step 219 to generate the fitted 2D parametric sketch model 218(a) or 218(b) from the decoded 2D shape 214(a) or 214(b).

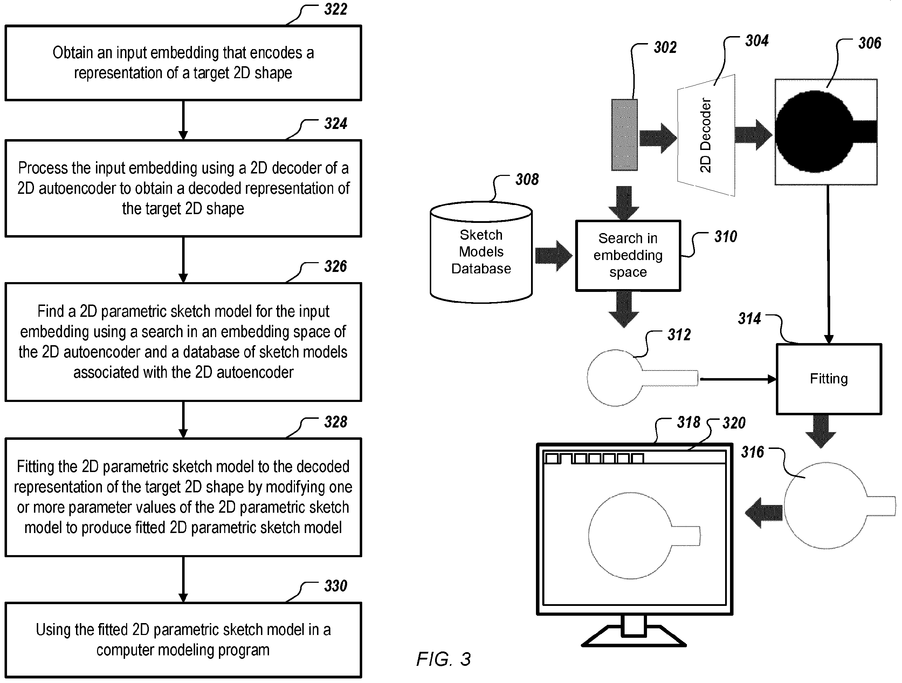

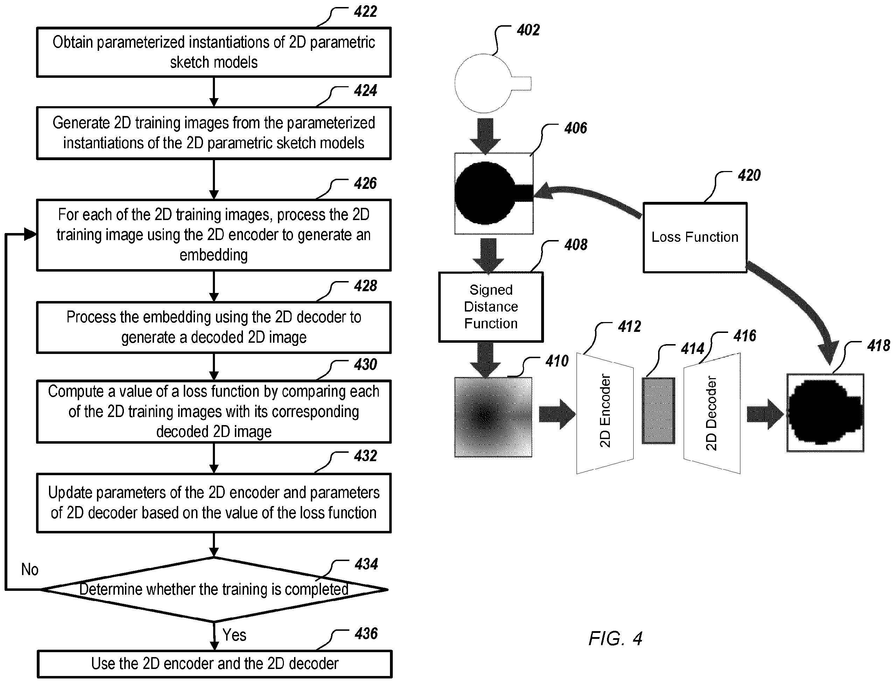

In some implementations, the search and fit step 219 can include the following. A 2D encoder 260 of a trained 2D autoencoder can generate an intermediate embedding 254 of the decoded 2D shape, e.g., the decoded 2D shape 214(a). The program(s) 116 can search, in a sketch models database 256, a 2D parametric sketch model 258 for the intermediate embedding 254, and the searching is performed in an embedding space of the trained 2D autoencoder. The program(s) 116 can fit the 2D parametric sketch model 258 to the decoded 2D shape 214(a) by modifying one or more parameter values of the 2D parametric sketch model 258 to produce the fitted 2D parametric sketch model 218(a). Details of the process of determining a fitted 2D parametric sketch model from an embedding are described below in connection with FIG. 3. In some implementations, each of the 2D shapes 214(a) and 214(b) can be probabilities (e.g., generated from scores through a sigmoid function) that indicate a likelihood that a pixel is inside the 2D shape, and the program(s) 116 can generate a signed distance field image for each 2D shape using the signed distance field function, e.g., the signed distance field function 408 of FIG. 4. The signed distance field images for the 2D shapes can be processed by the 2D encoder 260 to generate the embeddings, e.g., the intermediate embedding 254 of the 2D shape 214(a).

Referring again to FIG. 2B, a set of extrusion parameters is generated 237 from the sub-embeddings, by the program(s) 116. The program(s) 116 determines a respective set of extrusion parameters for each of the sub-embeddings. Referring to FIG. 2A, an envelope decoder can take a sub-embedding as input and can generate as output an envelope function. The program(s) 116 can determine the set of extrusion parameters from the envelope function.

The envelope decoder is previously trained to generate an envelope function. The envelope decoder can be implemented using a MLP or one or more one-dimensional deconvolution neural network layers. For example, an envelope decoder 217(a) can take the sub-embedding 210(a) as input and can generate an envelope function 216(a). An envelope decoder 217(b) can take the sub-embedding 210(b) as input and can generate an envelope function 216(b). The envelope function includes scores that indicate a likelihood of the start location or the end location. The scores can be converted into probability values by passing the scores through a sigmoid function. For example, the grayscale levels in the envelope functions 216(a) and 216(b) are the probabilities values indicating a likelihood of the start location or the end location.

In some implementations, the envelope decoder can include a start envelope decoder and an end envelope decoder. The start envelope decoder can take a sub-embedding as input and can generate as output a start envelope function, and the end envelope decoder can take the sub-embedding as input and can generate as output an end envelope function. The start envelope function and the end envelope function can be two 1D vectors of floating point numbers or other types of numeric values. The start envelope function can be used to determine a start location of the extrusion and the end envelope function can be used to determine an end location of the extrusion. The start function can be positive when a location is below the start plane of the extrusion and can be negative when a location is above the start plane of the extrusion. The end function can be negative when a location is below the end plane of the extrusion and can be positive when the location is above the end plane of the extrusion.

The set of extrusion parameters can include an extrusion start location and an extrusion end location for a corresponding fitted 2D parametric sketch model generated from the respective sub-embedding. The set of extrusion parameters can be used to perform extrusion of the fitted 2D parametric sketch model 218(a) and 218(b) into a 3D space. The extrusion start location and the extrusion end location can be determined from the envelope function. For example, from the envelope function 216(a), the program(s) 116 can determine an extrusion start location 213(a) and an extrusion end location 211(a) for the fitted parametric sketch model 218(a). From the envelope function 216(b), the program(s) 116 can determine an extrusion start location 213(b) and an extrusion end location 211(b) for the fitted 2D parametric sketch model 218(b).

In some implementations, the program(s) 116 can determine the extrusion start location from the start envelope function and can determine the extrusion end location from the end envelope function. In some implementations, the extrusion start location can be at a location where the start envelope function crosses zero, and the extrusion end location can be at a location where the end envelope function crosses zero. In some implementations, the start extrusion location and the end extrusion location can be the locations where the probability crosses a predetermined threshold, e.g., 50%. If more than one location crosses the predetermined threshold, the start location can be at the first crossing of the start envelope function and the end location can be at the last crossing of the end envelope function. The extrusion direction can be predetermined or hardcoded. In this example, the extrusion direction is in the z direction for both fitted 2D parametric sketch models 218(a) and 218(b). But note that the orientation of the extrusion direction can be another of the extrusion parameters, in some implementations.

In some implementations, one extrusion can start from the end of the previous extrusion. Thus, instead of having a start envelope decoder for a first 2D parametric sketch model and an end envelope decoder for a second 2D parametric sketch model, one envelope decoder can be used to generate a start-end envelope function that defines the shared plane/location. For example, the end envelope function, e.g., for determining the end location 211(b) of a lower extrusion (e.g., of the 2D parametric sketch model 218(b), can be (-1) times the start envelope function, e.g., for determining the start location 213(a)) of an upper extrusion (e.g., of the 2D parametric sketch model 218(a). This shared envelope function can be decoded by the same envelope decoder and can be shared by both extrusions.

Referring again to FIG. 2B, the fitted 2D parametric sketch models generated by the machine learning algorithm can be provided to a user to determine 238 whether the design is acceptable for the target 3D object, e.g., by the

EP 4 280 162 A1

program(s) 116. The program(s) 116 can include in the UI 122 a UI element that allows the user 190 to accept or reject the fitted 2D parametric sketch models generated by the machine learning algorithm. In some implementations, the program(s) 116 generates 240 a 3D B-Rep model using the fitted 2D parametric sketch models and the 3D B-Rep model is displayed to a user such that the user can decide to accept or reject the 3D B-Rep model.

If a user determines that the generated fitted 2D parametric sketch models are not acceptable to construct the target 3D object, the program(s) 116 can generate updated fitted 2D parametric sketch models using the machine learning algorithm. In some implementations, the program(s) 116 can include in the UI 122 UI element(s) that allow the user 190 to specify another set of extrusion directions. The machine learning algorithm can generate fitted 2D parametric sketch models with the other set of extrusion directions.

Once a user determines 238 that the generated fitted 2D parametric sketch models are acceptable to construct the target 3D object, a 3D boundary representation (B-Rep) model of the target 3D object is generated 240, by the program(s) 116. The program(s) 116 uses the fitted 2D parametric sketch models in a construction sequence (e.g., a parametric construction sequence) to construct the 3D B-Rep model through extrusion into a 3D space. The construction sequence includes the set of extrusion parameters (e.g., the start and end extrusion locations), the predetermined extrusion directions, and the predetermined Boolean operations defined in a CAD Boolean engine 222.

Referring to FIG. 2A, the program(s) 116 can extrude each of the fitted 2D parametric sketch models 218(a) or 218(b) into 3D. The program(s) 116 can include a CAD extrusion engine. The CAD extrusion engine can generate an extruded parametric sketch model from each fitted 2D parametric sketch model at the start and end extrusion locations included in the set of extrusion parameters and in the predetermined extrusion direction included in the construction sequence. For example, the CAD extrusion engine can generate a first extruded parametric sketch model from the fitted 2D parametric sketch model 218(a) using the set of extrusion parameters, e.g., the extrusion start location 213(a) and the extrusion end location 211(a). The CAD extrusion engine can generate a second extruded parametric sketch model from the fitted 2D parametric sketch model 218(b) using the set of extrusion parameters, e.g., the extrusion start location 213(b) and the extrusion end location 211(b). The program(s) 116 can include a CAD Boolean engine 222. The CAD Boolean engine 222 is non-differentiable. The CAD Boolean engine 222 can receive the extruded parametric sketch models (e.g., the first extruded parametric sketch model generated from 218(a) and the second extruded parametric sketch model generated from 218(b)) as input, and can generate a 3D boundary representation (B-Rep) model 220 through a set of predetermined (or hard coded) Boolean operations. The CAD Boolean engine 222 defines the set of predetermined (or hardcoded) Boolean operations, such as union operations, intersection operations, complement operations, or a combination thereof.

For example, the fitted 2D parametric sketch model 218(a) is extruded into 3D between the start and end extrusion locations determined from the envelope function 216(a) in the z direction, and the fitted 2D parametric sketch model 218(b) is extruded into 3D between the start and end extrusion locations determined from the envelope function 216(b) in the z direction. The CAD Boolean engine 222 can include a predetermined union operation. Thus the two 3D parametric sketch models extruded from the fitted 2D parametric sketch models 218(a) and 218(b) can be combined together through the union operation. In some cases, the CAD Boolean engine 222 can define an operation that is the multiplication of an intersection operation and the complement operation (e.g., -1), and this results in the subtraction of one 3D parametric sketch model from another 3D parametric sketch model. In some cases, the CAD Boolean engine 222 can define a sequence of union operations, intersection operations, complement operations, or a combination thereof.

The program(s) 116 can determine a set of connected surface elements specifying boundaries between a solid portion and a non-solid portion of the 3D B-Rep model 220. Thus, the geometry of the 3D B-Rep model 220 can be stored in the computer using smooth and precise mathematical surfaces. The program(s) 116 can store the 3D B-Rep model 220 in a local computer or send it to a remote computer. The program(s) 116 can display the 3D B-Rep model 220 in an UI 122 of a displaying device 120 of the computer 110. The program(s) 116 can generate toolpaths 165 for the 3D B-Rep model 160 or 220. The toolpaths 165 can be used by an SM and/or AM machine 170 to manufacture the target 3D object. In some implementations, the program(s) 116 can generate a 3D voxel model of the target 3D object from the 3D B-Rep model 220.

In some implementations, the program(s) 116 can use the process 200 to undo morphological modifications on a 3D voxel model. The program(s) 116 can obtain an initial voxel model of a target 3D object. The program(s) 116 can generate a modified voxel model 202 by processing the initial voxel model through a morphological modification. The program(s) 116 can generate the initial input embedding 206 by processing the modified voxel model 202 using the 3D encoder 204. The program(s) 116 can generate sub-embeddings 210(a) and 210(b) from the initial input embedding 206 of the modified voxel model 202. The program(s) 116 can determine fitted 2D parametric sketch models 218(a) and 218(b) based on the sub-embeddings. The program(s) 116 can generate a reconstructed 3D B-Rep model 220 from the fitted 2D parametric sketch models 218(a) and 218(b) using the construction sequence through the extrusion into the 3D space. The reconstructed 3D B-Rep model 220 can be similar to the initial voxel model, thus undoing the morphological modifications.

In some implementations, the program(s) 116 can generate a prismatic CAD model from an output of a gen-

10

erative design process. The program(s) 116 can obtain an initial voxel model 202 of a target 3D object, and the initial voxel model can be a generative design output. The program(s) 116 can generate the initial input embedding 206 by processing the initial voxel model 202 using the 3D encoder 204. The program(s) 116 can generate a 3D prismatic model of the target 3D object which is the 3D B-Rep model 220.

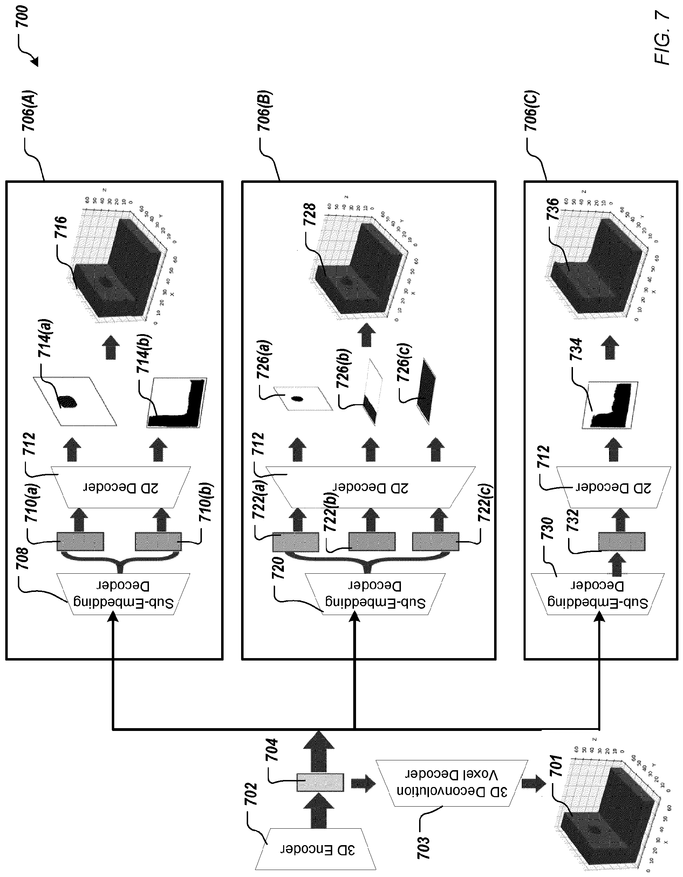

In some implementations, the 3D B-Rep model 220 can be post-processed, by the program(s) 116, to increase its similarity to the initial 3D voxel model 202 of the target 3D object. The program(s) 116 can obtain an initial 3D voxel model 202 of the target 3D object, wherein the initial 3D voxel model is generated from a generative design output. The program(s) 116 can generate the initial input embedding 206 by processing the initial voxel model 202 using the 3D encoder 204. After getting the 3D B-Rep model 220, the program(s) 116 can perform post-processing on the 3D B-Rep model 220. The program(s) 116 can fit the 3D B-Rep model 220 to the initial voxel model 202 of the target 3D object by changing one or more parameters of the 3D B-Rep model 220 to produce a fitted 3D B-Rep model. For example, fillets can be added to the 3D B-Rep model 220 to round out the edges of the 3D B-Rep model 220. In some implementations, when the initial 3D voxel model 202 is not available, the program(s) 116 can generate a decoded 3D voxel model from the input embedding 206 using a 3D deconvolution voxel decoder (e.g., the 3D deconvolution voxel decoder 703 described in connection with FIG. 7), and the program(s) 116 can perform fillet fitting on the 3D B-Rep model 220 based on the decoded 3D voxel model.

In some implementations, after generating the fitted 2D parametric sketch models 218(a) and 218(b), the program(s) 116 can fit fillet arcs to the fitted 2D parametric sketch models 218(a) and 218(b) to better approximate the shapes of the 2D profiles 214(a) and 214(b) decoded by the intermediate 2D decoder 212. Thus, the sketches in the sketch models database 256 can be defined mostly using lines, and it is easier to perform the fitting 259 using a constraint solver for sketches defined using lines. The fillet arc radius can be obtained from a signed distance function by evaluating that function at the vertex to be filleted. If the 2D shapes 214(a) and 214(b) are not generated with signed distance functions, a fast marching method can be used to generate signed distance values from the 2D shapes 214(a) and 214(b).

In some implementations, the parameters of the 2D parametric sketch model 258 can be fitted to better approximate the entire target voxel model 202 or the 3D voxel model generated by the 3D deconvolution voxel decoder. The program(s) 116 can use an optimization algorithm which does not require derivatives. In some implementations, the set of extrusion parameters (e.g., the extrusion start location and the extrusion end location) can be fitted to better approximate the entire target voxel model 202 or the 3D voxel model generated by the 3D deconvolution voxel decoder.

In some implementations, the fillets radii can be determined using a signed distance function by evaluating the average value of the signed distance function along each edge and then building a fillet with that average value as the radius. This removes the need for an optimization algorithm for fillet creation. If the voxel models available are not signed distance functions (e.g., when the voxel models are the output of the 3D deconvolution voxel decoder), a signed distance function can be created using the fast marching method.

FIG. 3 includes a flowchart showing an example of a process to generate a fitted 2D parametric sketch model of a target 2D shape by a machine learning algorithm. Given an embedding vector, a machine learning algorithm can find a 2D shape which represents the embedding vector and is similar to a human design, such as a sketch model previously designed by a human user.

An input embedding that encodes a representation of a target 2D shape is obtained 322, by the program(s) 116. For example, the program(s) 116 can receive an input embedding 302 that encodes a representation of a target 2D shape. An exact model of the target 2D shape is unknown and only certain aspects or desirable features of the target 2D shape is known. Thus, the input embedding 302 can represent the desirable features of the target 2D shape. For example, the input embedding 302 can be generated by encoding an initial design of the target 2D shape using a 2D encoder. As another example, the target 2D shape can be a shape that is related to two 2D shapes, and the input embedding 302 can be an interpolation of the two embeddings of the two 2D shapes. In some 2D implementations, the input embedding 302 can be an embedding of a 2D shape. In some 3D implementations, the input embedding 302 can be each of the respective sub-embeddings 210(a) and 210(b) generated from a 3D shape, e.g., the 3D voxel model 202.

The input embedding is processed 324, by the program(s) 116, using a 2D decoder of a 2D autoencoder to obtain a decoded representation of the target 2D shape. A 2D decoder 304 is previously trained and can decode the input embedding 302 to generate a 2D image 306 that is a decoded representation of the target 2D shape. The 2D decoder 304 belongs to a 2D autoencoder that includes a 2D encoder and the 2D decoder 304. The 2D autoencoder includes a 2D encoder that processes a representation of a 2D object to generate an object embedding, and the 2D decoder 304 that processes the object embedding to generate the decoded representation of the 2D object. Details of the process of training the 2D autoencoder are described below in connection with FIG. 4.

The 2D encoder can include a 2D convolutional neural network (CNN) including one or more convolutional layers with configurable sizes, one or more fully connected layers, one or more activation layers, or skip connections between the layers, etc. The 2D decoder 304 can include a CNN including one or more deconvolutional layers with configurable sizes, one or more transposed convolutional layers with configurable sizes, one or more fully connected layers, one or more activation layers, or skip connections between the layers, etc. The 2D decoder generates the 2D image 306 that is an approximate shape of the target 2D shape. The value of each pixel of the 2D image is a score indicating the likelihood or probability that the pixel is inside the approximate shape. In some implementations, the architecture of the 2D decoder 304 can mirror the architecture of the 2D encoder. For example, if the 2D encoder includes three convolution layers that output embeddings of sizes 32, 64, and 512, the 2D decoder can include three deconvolution layers that receive embeddings of sizes 512, 64, and 32.

A fitted 2D parametric sketch model for the input embedding is determined by the program(s) 116 through performing the operations 326 and 328. A 2D parametric sketch model for the input embedding is found 326, by the program(s) 116, using a search in an embedding space of the 2D autoencoder and a database of sketch models associated with the 2D autoencoder. The shape (e.g., including the translation in x and y and a uniform scale factor) of the 2D parametric sketch model is determined by one or more parameter values of the 2D parametric sketch model. The program(s) 116 performs search 310 in an embedding space of the 2D autoencoder using a sketch model database 308. The sketch model database includes previously computed embeddings for parametric variants of multiple 2D parametric sketch models.

To generate the sketch model database, the program(s) 116 obtains multiple 2D parametric sketch models. Each 2D parametric sketch model has constraints that control the dimension(s) and the rough shape. The details of the shape of each 2D parametric sketch model is flexible and can be determined by one or more parameter values of the 2D parametric sketch model. The program(s) 116 varies the one or more parameter values for each 2D parametric sketch model, creating many geometries or parametric variants for the 2D parametric sketch model. In some implementations, the parametric variants for the 2D parametric sketch models can be mirrored, rotated, and/or translated. Each parametric variant of each of the 2D parametric sketch models can be encoded using the 2D encoder of the 2D autoencoder to obtain an embedding. The embeddings of the different parametric variants of the multiple 2D parametric sketch models are saved in the sketch model database 308.

The program(s) 116 can find a 2D parametric sketch model 312 for the input embedding 302 using a search in the database 308. In some implementations, the program(s) 116 can search an embedding stored in the database 308 that is closest to the input embedding 302 in the embedding space of the 2D autoencoder, and the program(s) 116 can find the 2D parametric sketch model 312 that corresponds to the closet embedding.

In some implementations, the program(s) 116 can perform the search using a transformer generator. Examples of performing the search using a transformer generator can be found in DeepCAD (Wu, Rundi, Chang Xiao, and Changxi Zheng. "Deepcad: A deep generative network for computer-aided design models. "Proceedings of the IEEE/CVF International Conference on Computer Vision. 2021). Other examples include models described in: Engineering Sketch Generation for Computer-Aided Design, Karl D. D. Willis and Pradeep Kumar Jayaraman and Joseph G. Lambourne and Hang Chu and Yewen Pu, The 1st Workshop on Sketch-Oriented Deep Learning (SketchDL), CVPR 2021; Ganin, Yaroslav, et al. "Computer-aided design as language. " Advances in Neural Information Processing Systems 34 (2021); Para, Wamiq, et al. "Sketchgen: Generating constrained cad sketches. "Advances in Neural Information Processing Systems 34 (2021); Seff, Ari, et al. "Vitruvion: A Generative Model of Parametric CAD Sketches. " arXiv preprint arXiv:2109.14124 (2021).

The 2D parametric sketch model is fitted 328, by the program(s) 116, to the decoded representation of the target 2D shape by modifying the one or more parameter values of the 2D parametric sketch model to produce the fitted 2D parametric sketch model. The 2D parametric sketch model retrieved from a search in the database 308 can be further adjusted by modifying the one or more parameter values of the 2D parametric sketch model. Because the database 308 saves a limited number of parametric variations of the 2D parametric sketch model 312, the program(s) 116 can perform a fitting 314 of the 2D parametric sketch model 312 to the 2D image 306. The program(s) 116 can perform an optimization algorithm (e.g., a multi-dimensional optimization algorithm that does not require derivatives.) to modify the one or more parameter values of the 2D parametric sketch model 312 to obtain a fitted 2D parametric sketch model 316. Examples of the optimization algorithms that can be applied here include simplex optimization (i.e., the Nelder-Mead method), Baysian optimization, (adaptive) coordinate descent, Cuckoo search, and so on. As shown in FIG. 3, compared with the 2D parametric sketch model 312, the diameter of the circle of the fitted 2D parametric sketch model 316 and the length and/or width of the rectangle of the fitted 2D parametric sketch model 316 are adjusted. Thus the fitted 2D parametric sketch model 316 more closely matches the shape of the 2D image 306.

In some implementations, in addition to fitting the internal parameters of the parametric sketch model, the program(s) 116 can fit parameters defining the position of the parametric sketch model (e.g., the translation in x and y) and the scale of parametric sketch model (e.g., a uniform scale factor). In some implementations, the cost function used during the fitting 314 can be based on the probabilities which the 2D decoder 304 predicts that each pixel is inside the profile. Let $Pr(x,y)$ be the probability that a pixel at a location defined by integers x and y is inside in the profile. Let $Inside(x,y)$ be a value which is +1 if the pixel is inside the profile and -1 if it is outside. The cost function used during the fitting 314 can be

$$\text{cost} = \sum_{x,y}(0.5 - Pr(x,y)) * Inside(x,y). \qquad (1)$$

Here the sum is a sum over all pixels in the image of the 2D profile.

The fitted 2D parametric sketch model is used 330 in a computer modeling program, such as a CAD program. The program(s) 116 can display the fitted 2D parametric sketch model in a user interface (UI) of a computer modeling program. For example, the fitted 2D parametric sketch model 316 can be displayed in a UI 320 on a display device 318 of the computer, which can be operated using one or more input devices of the computer (e.g., keyboard and mouse). A user of the computer modeling program can make further modifications to the fitted 2D parametric sketch model 316. The user can incorporate the fitted 2D parametric sketch model 316 into a 3D B-Rep model being created. For example, the user can extrude the fitted 2D parametric sketch model 316 into a 3D space using CAD tools. In some implementations, the process of generating the fitted 2D parametric sketch model 316 can be a part of the automatic generation of a 3D B-Rep model. For example, the input embedding 302 can be the respective sub-embeddings 210(a) and 210(b) of FIG. 2A, and the fitted 2D parametric sketch model 316 can be the respective fitted 2D parametric sketch models 218(a) and 218(b).

FIG. 4 includes a flowchart showing an example of a process to train a 2D autoencoder that can be used to determine a fitted 2D parametric sketch model of a target 2D shape. Parameterized instantiations of 2D parametric sketch models are obtained 422, by the program(s) 116. The program(s) 116 obtains 2D parametric sketch models (e.g., profiles), and the shape of each 2D parametric sketch model is determined by one or more parameter values of the 2D parametric sketch model. A parameterized instantiation of a 2D parametric sketch model is a 2D shape of the 2D parametric sketch model with one or more determined parameter values. The program(s) 116 can vary the one or more parameter values of a 2D parametric sketch model and obtain a plurality of parameterized instantiations of 2D parametric sketch model. For example, the 2D shape 402 is a parameterized instantiation of a 2D parametric sketch model, e.g., with one parameter value that defines the size of the circle portion of the 2D parametric sketch model and another two parameter values that define the width and height of the rectangle portion of the 2D parametric sketch model.

2D training images are generated 424 from the parameterized instantiations of the 2D parametric sketch models, by the program(s) 116. Each of the 2D training images corresponds to a parameterized instantiation of a 2D parametric sketch model. For example, the program(s) 116 can generate a binary mask 406 of the parameterized instantiation 402 of the 2D parametric sketch model, and the binary mask 406 is one of the 2D training images that can be used to train a 2D autoencoder.

The 2D autoencoder is trained on the 2D training images, by the program(s) 116, following the operations 426, 428, 430, and 432. The 2D autoencoder includes a 2D encoder 412 and a 2D decoder 416. For each of the 2D training images, the 2D training image is processed 426, by the program(s) 116, using the 2D encoder to generate an embedding. During training, the 2D encoder 412 can receive a 2D training image 406 as input and can generate an embedding 414 of the 2D training image 406. The embedding 414 can be a one-dimensional embedding vector, e.g., with length 512, 1024, or 2048 bits, bytes, words, or double words.

In some implementations, a signed distance field image is generated from the 2D training image, and the signed distance field image is processed using the 2D encoder to generate the embedding. The program(s) 116 can process the 2D training image 406 using a signed distance function (SDF) 408 to obtain a signed distance field image 410 which can provide an improved description of a 2D shape. The SDF is a function which takes a position as an input, and outputs the distance from that position to the nearest part of a shape. The signed distance field image 410 can include pixel values that are floating point numbers, instead of binary values such as the pixel values in the 2D training image 406. Because binary images describe the shape only at the boundary between the black and white pixels, while a signed distance function can spread the signal over the entire image or pixel area, the signed distance field image 410 can provide a better description of the 2D shape 402 than the binary 2D training image 406, thus improving the performance of the 2D autoencoder.

For example, a pixel in a binary image can only provide information about an outline of a shape, but a pixel in a signed distance field image can provide information about the position of the pixel and information about the thickness of the shape at the pixel. Because CNNs, such as the 2D autoencoder, can have translational invariance, the same shape at different locations in the image can produce the same signature for a binary image, but the same shape at different locations in the image can produce a different signature for a signed distance field image, providing a better description of the 2D shape. For example, the embedding 414 generated from a signed distance field image 410 can describe both the 2D shape 402 and the pixels' relative position in the 2D training image 406. Experimental results show improvements of the performance of the 2D autoencoder using signed distance field images.

The embedding is processed 428, by the program(s) 116, using the 2D decoder to generate a decoded 2D image. The 2D decoder 416 can generate a decoded 2D image 418, and each pixel of the decoded 2D image 418 can be a score, e.g., a floating point number or other types of numeric values, indicating a likelihood that the pixel is inside the 2D shape. In some implementations, the program(s) 116 can pass the pixel values of the decoded 2D image 418 through a sigmoid function to obtain a probability that the pixel is inside the 2D shape. The sigmoid has the effect of converting the negative numbers to probabilities below a threshold, e.g., 50%, and converting the positive numbers to probabilities above a threshold, e.g., 50%. In some implementations, before applying the sigmoid function, a signed function can be applied to the decoded 2D image 418, and the signed function can be negative inside the 2D shape and positive outside the 2D shape.

A value of a loss function is computed 430, by the program(s) 116, by comparing each of the 2D training images with its corresponding decoded 2D image. The program(s) 116 can compare each 2D training image 406 with its corresponding decoded 2D image 418 using a loss function 420. The loss function can compare each of the predicted probabilities to the actual class indicated in the 2D training images. Examples of the loss function include the (binary) cross-entropy loss, the mean-squared error, the Huber loss, and the hinge loss.

Parameters of the 2D encoder and parameters of 2D decoder are updated 432, by the program(s) 116, based on the value of the loss function. The program(s) 116 can compute a value of the loss function over a batch of 2D training images selected from the 2D training images. The program(s) 116 can update the parameters of the 2D autoencoder, e.g., parameters of the 2D encoder and parameters of 2D decoder, based on the value of the loss function using an optimizer, such as stochastic gradient descent, through an iterative optimization process. The program(s) 116 can iteratively update the parameters of the 2D autoencoder over batches of the 2D training images.

A check can be made 434 for convergence of the optimization, e.g., the completion of the training of the 2D autoencoder. In some implementations, if the update of the parameters is smaller than a threshold, it can be determined that the iterative optimization process has converged. In some implementations, convergence occurs when the update has reached the limit of precision supported by the computer or the CAD program. In some implementations, the optimization converges when a fixed number of iterations has been performed.

After the training is completed, the program(s) 116 can use 436 the 2D autoencoder. The program(s) 116 can use the 2D encoder 412 to create a database of embeddings for parametric variations of multiple parametric sketch models. For example, the 2D encoder 412 can be used to generate the embeddings stored in the sketch model database 308 of FIG. 3 and/or the sketch database 130 of FIG. 1, which can be the same database in some implementations. The program(s) 116 can convert each parametric variation of a parametric sketch model to a signed distance field image using the signed distance field function 408. Then, the program(s) 116 can generate an embedding of the parametric variation of the parametric sketch model using the 2D encoder 412. The embedding and a mapping relationship with the parametric variation of the parametric sketch model can be stored in the sketch model database 308 and/or sketch database 130.

The program(s) 116 can use the trained 2D decoder 416 and the trained 2D encoder 412 in a process 200 to generate a 3D model of a target 3D object. In particular, the trained 2D decoder 416 can be the intermediate 2D decoder 212 of FIG. 2A or a portion thereof, and the trained 2D decoder can be used to determine fitted 2D parametric sketch models 218(a) and 218(b) for the sub-embeddings 210(a) and 210(b). The trained 2D encoder 412 can be the 2D encoder 260 of FIG. 2A or a portion thereof. The program(s) 116 can also use the trained 2D decoder 416 in a process 500 to train a 3D autoencoder that can be used to generate a 3D model of a target 3D object.

FIG. 5 shows an example of a process 500 to train a 3D autoencoder that can be used to generate a 3D model of a target 3D object. FIG. 6 is a flowchart showing an example of a process to train a 3D autoencoder that can be used to generate a 3D model of a target 3D object. The 3D autoencoder includes a 3D encoder 508 that processes an input voxel model to generate a 3D object embedding 510, a sub-embedding decoder 512 that processes the 3D object embedding 510 to generate the sub-embeddings (e.g., 514(a), 514(b), and 514(c)), an envelope decoder 517 that processes each of the sub-embeddings to generate a respective envelope function, and a differentiable Boolean engine that generates a reconstructed voxel model by expanding the 2D shapes into a 3D space using the envelope function. In some implementations, the envelope decoder 517 can include a start envelope decoder that processes each sub-embedding of the sub-embeddings to generate a start envelope function, and an end envelope decoder that processes each sub-embedding of the sub-embeddings to generate an end envelope function. A set of extrusion parameters (e.g., the start extrusion location and the end extrusion location of FIG. 2A) can be generated from the start envelope function and the end envelope function. For example, the set of extrusion parameters can be the extrusion parameters 211 and 213 of FIG. 2A that can be used to extrude 2D parametric sketch models into the 3D B-Rep model 220.

Referring again to FIG. 6, training examples are obtained 602, by the program(s) 116. Each training example includes a training voxel model and a ground truth voxel model. The training voxel model is generated from the ground truth voxel model. When the history information of generating the ground truth voxel model is available, each training example can further include ground truth 2D shapes and a set of ground truth expansion parameters (e.g., the start and end planes of each extrusion) that defines a ground truth envelope function. The ground truth voxel model was generated by expanding the ground truth 2D shapes into a 3D space using the set of ground truth expansion parameters. When the history information of generating the ground truth voxel model is not available, the ground truth 2D shapes and the set of ground truth expansion parameters are not included in the training example. In some implementations, the 3D autoencoder can be trained directly on the ground truth voxel models. Thus, each training example includes the ground truth voxel model, and the program(s) 116 does not need to generate a training voxel model from the ground truth voxel model.

For example, referring to FIG. 5, the program(s) 116 can obtain a plurality of training examples, and each training example can include a training voxel model 506, a ground truth voxel model 502, and ground truth 2D shapes 528 including three 2D shapes 528(a), 528(b), and 528(c). To generate the plurality of training examples, the program(s) 116 can obtain a plurality of ground truth voxel models. The program(s) 116 can generate one or more training voxel models 506 from each ground truth voxel model 502 through data augmentation. For example, the program(s) 116 can perform various kinds of morphological modifications 504 to the ground truth voxel 502 to obtain a plurality of training voxel models, such as a training voxel model 506 with a blobby or fuzzy shape and an additional hole 507. Through the morphological operations, the training voxel model 506 can have rounded edges and the training voxel model 506 can have a similar shape as the kinds of models created by topology optimization or generative design. In some implementations, the training voxel model can be a training signed distance field voxel model generated using a 3D signed distance function in a 3D grid.

Using the ground truth voxel model 502 as the ground truth, the 3D autoencoder can be trained using supervised learning, e.g., using a first loss function 524. For example, the 3D autoencoder can be trained to undo the morphological modification 504 by generating a 3D voxel model 522 from a blobby or fuzzy input voxel model 506. Thus, the 3D autoencoder can be trained to generate 3D prismatic B-Rep CAD models from models created by topology optimization or generative design.

In some implementations, when the history information of generating the ground truth voxel model is available, each ground truth voxel model 502 can be defined by the ground truth 2D shapes 528. That is, the ground truth voxel model 502 was generated by expanding the ground truth 2D shapes 528 using a set of ground truth expansion parameters that defines a ground truth envelope function. The ground truth envelope function can be the max or the intersection of a ground truth start envelope function and a ground truth end envelope function. The ground truth start envelope function and the ground truth end envelope function can be two 1D vectors of binary values. Thus, when the ground truth 2D shapes and the corresponding ground truth start and end envelope functions are available to the program(s) 116, the ground truth 2D shapes and the corresponding ground truth expansion parameters can be used as additional ground truth labels to train the 3D autoencoder using supervised learning, e.g., using a second loss function 526 in addition to the first loss function 524. In particular, the ground truth start and end envelope functions can be used to train the envelope decoder 517 (e.g., including the start envelope decoder and the end envelope decoder) using supervised learning.

For example, the 2D shapes 528(a), 528(b), and 528(c) are at the x-y plane, the x-y plane, and the y-z plane, respectively. The ground truth voxel model 502 can be generated by generating three intermediate 3D shapes by: expanding the 2D shape 528(a) in z direction at locations defined by the ground truth start and end envelope function for the 2D shape 528(a), expanding the 2D shape 528(b) in z direction at locations defined by the ground truth start and end envelope function for the 2D shape 528(b), and expanding the 2D shape 528(c) in x direction at locations defined by the ground truth start and end envelope function for the 2D shape 528(b). The three intermediate 3D shapes can be combined through union operations (e.g., minimum operations), intersection operations (e.g., maximum operations), and the complement operation (e.g., minus 1). For example, the ground truth voxel model 502 can be generated by taking a union of the 3D shapes that correspond to the 2D shapes 528(a) and 528(b), and then subtracting the 3D shape that corresponds to the 2D shape 528(c), e.g., through intersection and complement operations.

Referring again to FIG. 6, the 3D autoencoder is trained on the training examples following the operations 604, 606, 608, 610, 612, 614, and 616. For each of the training examples, the training voxel model is processed 604, by the program(s) 116, using the 3D encoder of the 3D autoencoder to generate a 3D object embedding of the training voxel model. Referring to FIG. 5, the 3D encoder 508 receives the training voxel model 506 as input and generates a 3D object embedding 510 of the training voxel model 506. The 3D object embedding 510 can be a one-dimension vector with a predetermined length, e.g., 512, 1024, or 2048 bits, bytes, words, or double words.

Referring again to FIG. 6, the 3D object embedding is processed 606, by the program(s) 116, using the sub-embedding decoder of the 3D autoencoder to generate the sub-embeddings. Referring to FIG. 5, the sub-embedding decoder 512 receives the 3D object embedding 510 as input and generates sub-embeddings 514(a), 514(b), and 514(c). The number of sub-embeddings and the orientations of the 2D shapes corresponding to the sub-embeddings can be predetermined by the sub-embedding decoder. For example, the sub-embedding decoder 512 can be configured to generate three sub-embeddings that correspond to shapes in the y-z plane (e.g., 518(a)), in the x-y plane (e.g., 518(b)), and in the x-y plane (e.g., 518(c)).

Referring again to FIG. 6, each sub-embedding of the sub-embeddings is processed 608, by the program(s) 116, to generate a 2D shape and start and end envelope functions. The program(s) 116 processes each sub-embedding using the 2D decoder 516 to generate the 2D shape. The program(s) 116 processes each sub-embedding using the envelope decoder 517 to generate an envelope function for the 2D shape. In some implementations, the envelope decoder 517 includes a start envelope decoder and an end envelope decoder. The program(s) 116 can process each sub-embedding using the start envelope decoder to generate a start envelope function. The program(s) 116 can process each sub-embedding using the end envelope decoder to generate an end envelope function.

Referring to FIG. 5, the 2D decoder 516 decodes each sub-embeddings to generate a corresponding 2D shape 518. For example, the 2D decoder 516 decodes the sub-embedding 514(a) to generate the 2D shape 518(a). The 2D decoder 516 decodes the sub-embedding 514(b) to generate the 2D shape 518(b). The 2D decoder 516 decodes the sub-embedding 514(c) to generate the 2D shape 518(c).

In some implementations, the 2D decoder 516 can be the same intermediate 2D decoder 212 used to determine fitted 2D parametric sketch models at inference time and the 2D decoder can belong to the 2D autoencoder that has been previously trained through a process described in connection with FIG. 4. The program(s) 116 can freeze the parameters of the trained 2D decoder during the training of the 3D autoencoder. That is, the parameters of the trained 2D decoder are not updated during the training of the 3D autoencoder. Thus, the 3D autoencoder can be trained such that the sub-embeddings 514(a), 514(b), and 514(c) generated from the sub-embedding decoder 512 is in the same embedding space of the intermediate 2D decoder 212 used at inference time. Therefore, during inference, referring to the process 200 of FIG. 2A, the trained intermediate 2D decoder 212 can determine the fitted 2D parametric sketch models 218(a) and 218(b) from the sub-embeddings 210(a) and 210(b) generated by the sub-embedding decoder 208. The intermediate 2D decoder 212 of FIG. 2A, the 2D decoder 516 of FIG. 5, the 2D decoder 304 of FIG. 3 can be the same 2D decoder trained using the process described in FIG. 4.

In some implementations, the 2D decoder 516 can be a 2D decoder that is different from the 2D decoder 416 of the 2D autoencoder described in connection with FIG. 4 that can be used to determine fitted 2D parametric sketch models for an input embedding. That is, the 2D decoder 516 has not been trained to determine the fitted 2D parametric sketch models for an input embedding. In some cases, the 2D decoder 516 can have the same architecture as the 2D decoder 416 but can have different parameter values. In some cases, the 2D decoder 516 can have a different architecture than the 2D decoder 416. The parameters of the 2D decoder 516 can be trained together with the parameters of the 3D autoencoder. Thus, the sub-embeddings 514(a), 514(b), and 514(c) directly generated from the sub-embedding decoder 512 are in an embedding space that is different from the embedding space defined by the intermediate 2D decoder 212 of FIG. 2A.

Therefore, during inference, referring to the process 200 of FIG. 2A, additional processing can be used as shown in block 219. The program(s) 116 can process the decoded 2D shape 214(a) using a 2D encoder 260, and the 2D encoder 260 is the same as the 2D encoder 412 of the trained 2D autoencoder that was used to generate the embeddings of the sketch models in the sketch models database 256. Thus, the program(s) 116 can search for a 2D parametric sketch model 258 for the intermediate embedding 254 in an embedding space of the trained 2D autoencoder.

Referring back to FIG. 5, in some implementations, the envelope decoder 517 generates an envelope function from each sub-embedding. In some implementations, the envelope decoder 517 can include a start envelope decoder and an end envelope decoder. The start envelope decoder can generate a start envelope function from the sub-embedding. The end envelope decoder can generate an end envelope function from the sub-embedding. The start and envelope function can determine an envelope function. In some implementations, the max or the intersection of the start and end envelope functions can be the envelope function. The envelope function can be used to generate the enveloped extrusion of the 2D shape, e.g., 521(a), 521(b), or 521(c).

Referring again to FIG. 6, a reconstructed voxel model of the training voxel model is generated 610, by the program(s) 116, by using the 2D shapes in a predicted construction sequence to construct the reconstructed voxel model through the expansion in the 3D space. Referring to FIG. 5, the program(s) 116 generates the reconstructed voxel model 522 from the 2D shapes 518 using a predicted construction sequence. The predicted construction sequence includes the envelope functions, the operations defined in the differentiable Boolean engine 520, and predefined expansion directions.

In some implementations, the program(s) 116 can include a differential expansion engine 519. The differential expansion engine 519 can generate three intermediate 3D shapes by expanding each 2D shape 518(a), 518(b), or 518(c) in the predetermined expansion direction. For example, the differentiable 2D shape 518(a), 518(b), or 518(c) can be copied along the predetermined or hard-coded axis of a 3D grid. The program(s) 116 can process each of the intermediate 3D shapes using the corresponding envelope function to generate the enveloped expansion.. For example, the max or the intersection of the envelope function and the intermediate 3D shape can be the enveloped expansion. The envelope function can be applied to the expanded 2D shape orthogonal to the predetermined or hard-coded expansion axis, using a max function to define the intersection. The 3D shape 521(a) is an enveloped expansion of the 2D shape 518(a), and the 3D shape 521(b) is an enveloped expansion of the 2D shape 518(b), and the 3D shape 521(c) is an enveloped expansion of the 2D shape 518(c). A differential Boolean engine 520 can process the envelope expansions to generate a reconstructed 3D voxel model 522. For example, the enveloped expansions 521(a), 521(b), and 521(c) can be combined using union operations, intersection operations, complement operations, or a combination thereof, defined in the differentiable Boolean engine 520.

Referring again to FIG. 6, a value of a first loss function is computed 612, by the program(s) 116, by comparing each training voxel model with its corresponding reconstructed voxel model. Referring to FIG. 5, the program(s) 116 can measure the difference between the reconstructed voxel model 522 with the ground truth voxel model 502 using the first loss function 524. Examples of the first loss function include the (binary) cross-entropy loss, the mean-squared error, the Huber loss, and the hinge loss. The first loss function allows the machine learning model to be trained without requiring training examples from a sketch based history.

In some implementations, a value of a second loss function is computed 614, by comparing the ground truth 2D shapes with the 2D shapes, and by comparing the start and end envelope functions with the ground truth envelope function. The program(s) 116 can measure the difference between the 2D shapes 518(a), 518(b), and 518(c) with the ground truth 2D shape 528 using the second loss function 526. Examples of the second loss function include the cross-entropy loss, the mean-squared error, the Huber loss, and the hinge loss. In some implementations, the program(s) 116 can also measure the difference between the start and end envelope functions with the ground truth envelope function using the second loss function 526. The second loss function allows the 3D autoencoder to learn to decompose the 3D shape into CAD-like 2D profiles. Thus, with the supervision of the second loss function, the 3D autoencoder can be trained to generate 2D profiles or shapes which can be useful for CAD extrusions.

Referring again to FIG. 6, parameters of the 3D autoencoder are updated, by the program(s) 116, based at least on the value of the first loss function. In some implementations, parameters of the 3D autoencoder are updated 616 based at least on the value of the first loss function and the value of the second loss function. Referring to FIG. 5, parameters of the 3D encoder 508, parameters of the sub-embedding decoder 512, and parameters of the envelope decoder 517 can be updated based on the value of the first loss function 524. In some implementations, parameters of the 3D encoder 508 and parameters of the sub-embedding decoder 512 can be updated based on a sum (or weighted sum) of the value of the first loss function 524 and the value of the second loss function. In some implementations, parameters of the 2D decoder 516 can also be updated during the training of the 3D autoencoder. The parameters of the 3D autoencoder can be updated based on the value of the first and/or the second loss function using an optimizer, such as stochastic gradient descent, through an iterative optimization process. The program(s) 116 can iteratively update the parameters of the 3D autoencoder over batches of the training examples.

A check can be made 618 for convergence of the optimization, e.g., the completion of the training of the 3D autoencoder. In some implementations, if the update of the parameters is smaller than a threshold, it can be determined that the iterative optimization process has converged. In some implementations, convergence occurs when the update has reached the limit of precision supported by the computer or the CAD program. In some implementations, the optimization converges when a fixed number of iterations has been performed.

After the training is completed, the program(s) 116 can use 620 the trained 3D autoencoder. The program(s) 116 can use the trained sub-embedding decoder and in a process 200 to generate a 3D model of a target 3D object. In particular, the trained sub-embedding decoder 512 can be the sub-embedding decoder 208 of FIG. 2A, and the trained sub-embedding decoder 512 can be used to decode the embedding 206 to the sub-embeddings 210(a) and 210(b). The trained envelope decoder 517 can be the envelope decoder 217(a) and 217(b) of FIG. 2A, and can be used to generate a start envelope function and an end envelope function from the sub-embeddings. The program(s) 116 can also use the trained 3D encoder 508 as the 3D encoder 204 in the process 200 to generate the embedding 206 from a representation 202 of a target 3D object.

FIG. 7 shows an example of a neural network architecture 700 for a 3D autoencoder that can be used to generate a 3D model of a target 3D object. The 3D autoencoder includes a 3D encoder 702 and multiple decoding modules, such as sub-decoders 706(A), 706(B), 706(C), etc. Each of the decoding modules corresponds to a different predefined set of expansion directions. Each of the decoding modules includes a respective sub-embedding decoder and a respective differentiable Boolean engine to generate 3D voxel models. A 3D object can be expanded from 2D shapes using a construction sequence that includes expansion/extrusion directions and Boolean operations. Although many different 3D objects exist, many 3D objects can be constructed through a finite number of construction sequences. The 3D autoencoder can determine a finite number of combinations of expansion/extrusion directions. The 3D autoencoder can determine a finite number of Boolean operations for each combination of extrusion directions. Thus, the 3D autoencoder can include a finite number (e.g., 18) of decoding modules and each decoding module can have a set of predetermined extrusion/expansion directions and a set of Boolean operations predetermined in the corresponding differentiable Boolean engine. The same 2d decoder 712 can be shared between all the decoding modules.

For example, the 3D autoencoder architecture 700 can include two or more decoding modules. The decoding module 706(A) includes a sub-embedding decoder 708 that can be trained to generate sub-embeddings 710(a) and 710(b) that encodes a 2D shape, e.g., the shape 714(a), in the y-z plane, and a 2D shape, e.g., the shape 714(b), in the x-z plane. The expansion directions of the 2D shapes 714(a) and 714(b) are predefined, e.g., in the x direction and in the y direction, respectively. The expansion of the 2D shapes 714(a) and 714(b) can be combined through a differentiable Boolean engine that defines predetermined union operations, intersection operations, complement operations, or a combination thereof, to generate the 3D voxel model 716. The decoding module 706(B) includes a sub-embedding decoder 720 that can be trained to generate sub-embeddings 722(a), 722(b), and 722(c) that encodes three 2D shapes.

The three 2D shapes can include, for example, the shape 726(a) in the y-z plane, the shape 726(b) in the x-y plane, and the shape 726(c) in the x-y plane. The expansion directions of the three 2D shapes are predefined, e.g., in the x direction, in the z direction, and in the z direction, respectively. The expansion of the 2D shapes 726(a), 726(b), and 726(c) can be combined through a differentiable Boolean engine that defines predetermined union operations, intersection operations, complement operations, or a combination thereof, to generate the 3D voxel model 728. The decoding module 706(C) includes a sub-embedding decoder 730 that can be trained to generate a sub-embedding 732 that encodes a 2D shape. The 2D shape can include, for example, the shape 734 in the x-z plane. The expansion direction of the 2D shape 734 is predefined, e.g., in the y direction. The expansion of the 2D shape 734 can result in the 3D voxel model 736.

During the training of the 3D autoencoder, e.g., the process 500 of FIG. 5, the program(s) 116 can determine the expansion directions and Boolean operations for each ground truth voxel model, and classify the ground truth voxel model into different categories. Training examples with ground truth voxel models of each category can be selected to train the respective decoding module that operates with the corresponding expansion directions and Boolean operations.

At inference, e.g., the process 200 of FIG. 2A, the program(s) 116 can obtain a representation 701 of a target 3D object and can determine one or more possible construction sequences. Each construction sequence can include a set of extrusion directions and Boolean operations. The program(s) 116 can select a decoding module of the 3D autoencoder architecture 700 that operates on the extrusion directions and Boolean operations, and can generate a 3D B-Rep model using the selected decoding module. The selection of the decoding module can be performed automatically by a computer program or can be performed by a user through a UI.

For example, for an input 3D shape 701, the program(s) 116 can select the decoding module 706(A) that extrudes the 2D shape 714(a) in the x direction and extrudes the 2D shape 714(b) in the y direction. Alternatively, for an input 3D shape 701, the program 116 can also select the decoding module 706(B) that extrudes two x-y plane 2D shapes in the z direction and extrudes one y-z plane 2D shape in the x direction. Either decoding module can generate a satisfactory 3D B-Rep model. The program(s) 116 can determine that the decoding module 706(C) cannot generate a satisfactory 3D B-Rep model that only extrudes a single x-z plane 2D shape in the y direction, e.g., the hole cannot be generated. In some implementations, a user can generate 3D B-Rep models using two or more decoding modules and can select a preferred 3D B-Rep model from the results.

In some implementations, at inference, e.g., the process 200 of FIG. 2A, the program(s) 116 can receive an initial input embedding 704 that encodes a representation of a target 3D object, without receiving the target geometry. The program(s) 116 can generate a decoded 3D voxel model 701 from the initial input embedding using a 3D deconvolution voxel decoder 703 that is previously trained to decode the initial input embedding 206 into a 3D shape. The 3D deconvolution voxel decoder 703 can include a CNN including one or more 3D deconvolutional layers with configurable sizes, one or more 3D transposed convolution layers with configurable sizes, one or more fully connected layers, one or more activation layers, or skip connections between the layers, etc. Each voxel of the decoded 3D voxel model 701 can be a score indicating a likelihood that the voxel is filled with a material. Then the program(s) 116 can determine the possible construction sequences based on the decoded 3D voxel model, and can select a decoding module based on the possible construction sequences. For example, the program(s) 116 can receive an initial embedding 704 without receiving the target 3D geometry of the 3D shape. The program(s) 116 can use a 3D deconvolution voxel decoder 703 to process the initial embedding 704 as input and to generate a decoded 3D voxel model 701. Based on the shape of the decoded 3D voxel model 701, the program(s) 116 can determine that either the decoding module 706(A) or the decoding module 706(B) can generate a satisfactory 3D B-Rep model.

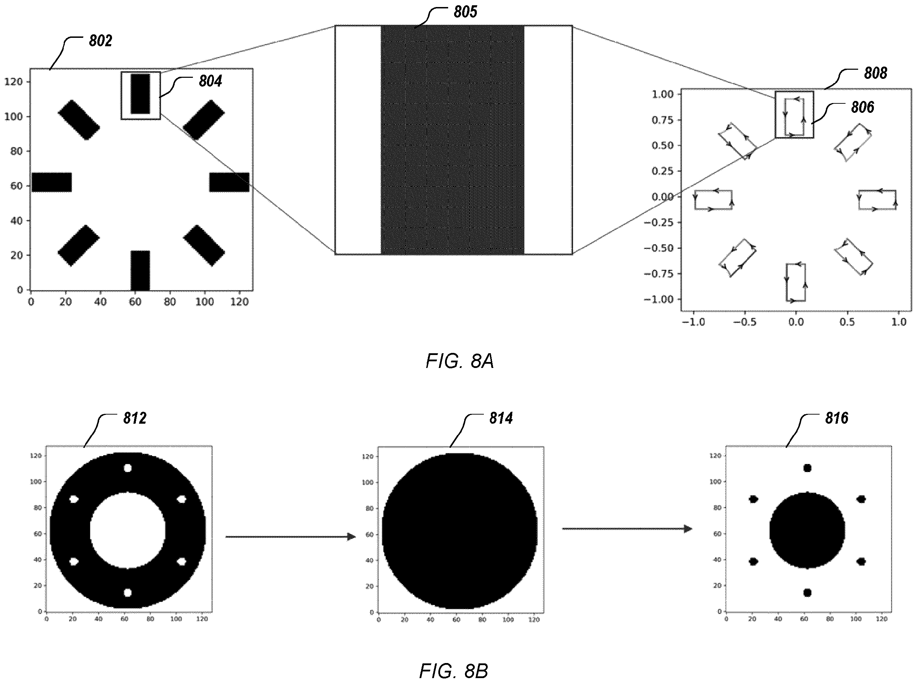

FIG. 8A shows an example of a process to determine fitted 2D parametric sketch models for a complex 2D shape. An input 2D image is obtained by the program(s) 116. The input 2D image includes two or more 2D shapes. For example, an input 2D image 802 is obtained by the program(s) 116. The input 2D image 802 includes eight rectangles at eight different locations of the image 802 and at eight different orientations. One of the rectangles is the rectangle 804.

Sub-image portions are generated, by the program(s) 116, from the input 2D image. Each sub-image portion depicts a 2D shape of the two or more 2D shapes. For example, eight image patches that include each of the eight rectangles can be generated, e.g., through connected-component analysis. For example, an image patch 805 can be generated for the rectangle 804. A respective sub-image portion embedding is generated, by the program(s) 116, for each sub-image portion of the sub-image portions. The program(s) 116 can generate eight sub-image portion embeddings by encoding the eight sub-image portions using the 2D encoder 412 of the 2D autoencoder trained in a process as described in FIG. 4.

Fitted 2D parametric sketch models are determined by the program(s) 116. That is, a fitted 2D parametric sketch model is determined for each sub-image portion embedding. For example, a fitted 2D parametric sketch model 806 can be determined for the sub-image portion embedding of the image patch 805. A combined 2D parametric sketch model is generated, by the program(s) 116, by combining the fitted 2D parametric sketch models at respective locations of the sub-image portions. For example, the eight 2D fitted parametric sketch models can be combined at the respective locations of the sub-image portions to generate the combined 2D parametric sketch model 808.

FIG. 8B shows an example of a process to generate sub-image portions, e.g., inner and outer loops, from an input 2D image. The program(s) 116 can obtain an input 2D image 812. The input 2D image includes a circular 2D object with one big hole at the center and six small holes. The program(s) 116 can fill the big and small holes of the input 2D image 812, e.g., through morphological operations, to obtain the 2D image 814. The program(s) 116 can generate a difference image 816 between the 2D image 814 and the input 2D image 812, e.g., through subtraction. The difference image 816 includes seven sub-portions, e.g., the big circle in the middle and six small circles. The program(s) 116 can separately determine a fitted 2D parametric sketch model for each of the seven circles. The program(s) 116 can generate a combined 2D parametric sketch model for the difference image 816 by combining the fitted 2D parametric sketch models for the seven circles. The program(s) 116 can generate 2D parametric sketch model for the input 2D image 812 by combining the fitted 2D parametric sketch model of the 2D image 814 and a complement of the combined 2D parametric sketch model for the difference image 816 because the input 2D image 812 can be generated by subtracting the seven circles from the 2D image 814.

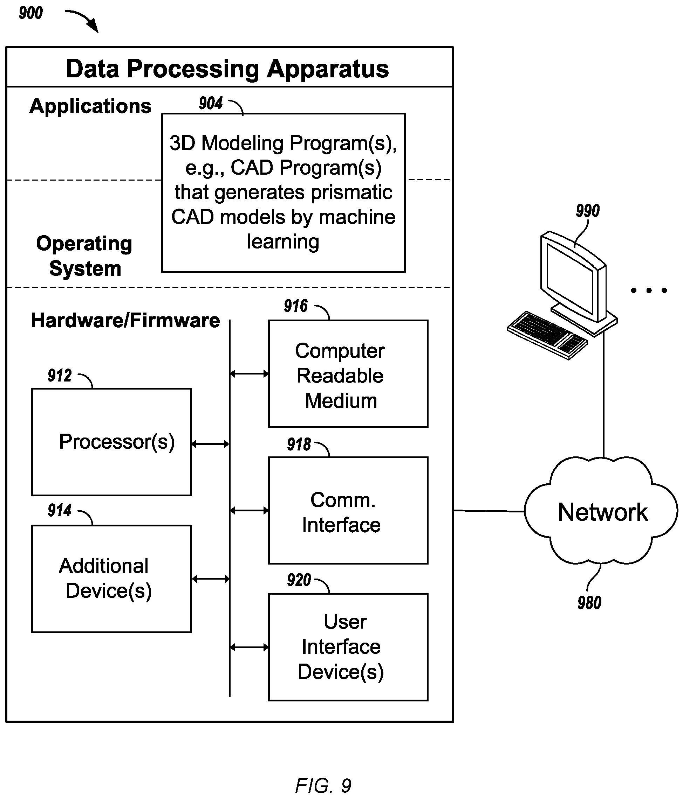

FIG. 9 is a schematic diagram of a data processing system including a data processing apparatus 900, which can be programmed as a client or as a server. The data processing apparatus 900 is connected with one or more computers 990 through a network 980. While only one computer is shown in FIG. 9 as the data processing apparatus 900, multiple computers can be used. The data processing apparatus 900 includes various software modules, which can be distributed between an application layer and an operating system. These can include executable and/or interpretable software programs or libraries, including tools and services of one or more 3D modeling programs 904 that implement the systems and techniques described above. Thus, the 3D modeling program(s) 904 can be CAD program(s) 904 and can implement generating prismatic B-Rep CAD models by machine learning algorithm(s). Further, the program(s) 904 can potentially implement manufacturing control operations (e.g., generating and/or applying toolpath specifications to effect manufacturing of designed objects). In some cases, the program(s) 904 can potentially implement building construction management or video and movie production. The number of software modules used can vary from one implementation to another. Moreover, the software modules can be distributed on one or more data processing apparatus connected by one or more computer networks or other suitable communication networks.

The data processing apparatus 900 also includes hardware or firmware devices including one or more processors 912, one or more additional devices 914, a computer readable medium 916, a communication interface 918, and one or more user interface devices 920. Each processor 912 is capable of processing instructions for execution within the data processing apparatus 900. In some implementations, the processor 912 is a single or multi-threaded processor. Each processor 912 is capable of processing instructions stored on the computer readable medium 916 or on a storage device such as one of the additional devices 914. The data processing apparatus 900 uses the communication interface 918 to communicate with one or more computers 990, for example, over the network 980. Examples of user interface devices 920 include a display, a camera, a speaker, a microphone, a tactile feedback device, a keyboard, a mouse, and VR and/or AR equipment. The data processing apparatus 900 can store instructions that implement operations associated with the program(s) described above, for example, on the computer readable medium 916 or one or more additional devices 914, for example, one or more of a hard disk device, an optical disk device, a tape device, and a solid state memory device.

Embodiments of the subject matter and the functional operations described in this specification can be implemented in digital electronic circuitry, or in computer software, firmware, or hardware, including the structures disclosed in this specification and their structural equivalents, or in combinations of one or more of them. Embodiments of the subject matter described in this specification can be implemented using one or more modules of computer program instructions encoded on a non-transitory computer-readable medium for execution by, or to control the operation of, data processing apparatus. The computer-readable medium can be a manufactured product, such as a hard drive in a computer system or an optical disc sold through retail channels, or an embedded system. The computer-readable medium can be acquired separately and later encoded with the one or more modules of computer program instructions, such as by delivery of the one or more modules of computer program instructions over a wired or wireless network. The computer-readable medium can be a machine-readable storage device, a machine-readable storage substrate, a memory device, or a combination of one or more of them.

The term "data processing apparatus" encompasses all apparatus, devices, and machines for processing data, including by way of example a programmable processor, a computer, or multiple processors or computers. The apparatus can include, in addition to hardware, code that creates an execution environment for the computer program in question, e.g., code that constitutes processor firmware, a protocol stack, a database management system, an operating system, a runtime environment, or a combination of one or more of them. In addition, the apparatus can employ various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a module, component, subroutine, or other unit suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub-programs, or portions of code). A computer program can be deployed to be executed on one computer or on multiple computers that are located at one site or distributed across multiple sites and interconnected by a communication network.

The processes and logic flows described in this specification can be performed by one or more programmable processors executing one or more computer programs to perform functions by operating on input data and generating output. The processes and logic flows can also be performed by, and apparatus can also be implemented as, special purpose logic circuitry, e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for performing instructions and one or more memory devices for storing instructions and data. Generally, a computer will also include, or be operatively coupled to receive data from or transfer data to, or both, one or more mass storage devices for storing data, e.g., magnetic, magneto-optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device (e.g., a universal serial bus (USB) flash drive), to name just a few. Devices suitable for storing computer program instructions and data include all forms of non-volatile memory, media and memory devices, including by way of example semiconductor memory devices, e.g., EPROM (Erasable Programmable Read-Only Memory), EEPROM (Electrically Erasable Programmable Read-Only Memory), and flash memory devices; magnetic disks, e.g., internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described in this specification can be implemented on a computer having a display device, e.g., an LCD (liquid crystal display) display device, an OLED (organic light emitting diode) display device, or another monitor, for displaying information to the user, and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input.

The computing system can include clients and servers. A client and server are generally remote from each other and typically interact through a communication network. The relationship of client and server arises by virtue of computer programs running on the respective computers and having a client-server relationship to each other. Embodiments of the subject matter described in this specification can be implemented in a computing system that includes a back-end component, e.g., as a data server, or that includes a middleware component, e.g., an application server, or that includes a front-end component, e.g., a client computer having a graphical user interface or a Web browser through which a user can interact with an implementation of the subject matter described is this specification, or any combination of one or more such back-end, middleware, or front-end components. The components of the system can be interconnected by any form or medium of digital data communication, e.g., a communication network. Examples of communication networks include a local area network ("LAN") and a wide area network ("WAN"), an inter-network (e.g., the Internet), and peer-to-peer networks (e.g., ad hoc peer-to-peer networks).

While this specification contains many implementation details, these should not be construed as limitations on the scope of what is being or may be claimed, but rather as descriptions of features specific to particular embodiments of the disclosed subject matter. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desired results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the invention have been described. Other embodiments are within the scope of the following claims.

EMBODIMENTS

Although the present invention is defined in the claims, it should be understood that the present invention can also (alternatively) be defined in accordance with the following embodiments:

1. A method comprising:

obtaining an input embedding that encodes a representation of a target two-dimensional (2D) shape;
processing the input embedding using a 2D decoder of a 2D autoencoder to obtain a decoded representation of the target 2D shape, wherein the 2D autoencoder comprises a 2D encoder that processes a representation of a 2D object to generate an object embedding, and the 2D decoder that processes the object embedding to generate the decoded representation of the 2D object;
determining a fitted 2D parametric sketch model for the input embedding, comprising:

finding a 2D parametric sketch model for the input embedding using a search in an embedding space of the 2D autoencoder and a database of sketch models associated with the 2D autoencoder, wherein a shape of the 2D parametric sketch model is determined by one or more parameter values of the 2D parametric sketch model; and
fitting the 2D parametric sketch model to the decoded representation of the target 2D shape by modifying the one or more parameter values of the 2D parametric sketch model to produce the fitted 2D parametric sketch model; and

using the fitted 2D parametric sketch model in a computer modeling program.

2. The method of embodiment 1, comprising:

obtaining parameterized instantiations of 2D parametric sketch models;
generating 2D training images from the parameterized instantiations of the 2D parametric sketch models, wherein each of the 2D training images corresponds to a parameterized instantiation of a 2D parametric sketch model; and
training the 2D autoencoder on the 2D training images, comprising:
for each of the 2D training images:

processing the 2D training image using the 2D encoder to generate an embedding; and
processing the embedding using the 2D decoder to generate a decoded 2D image;
computing a value of a loss function by comparing each of the 2D training images with its corresponding decoded 2D image; and
updating parameters of the 2D encoder and parameters of the 2D decoder based on the value of the loss function.

3. The method of embodiment 2, wherein the training the 2D autoencoder on the 2D training images comprises:

generating a signed distance field image from the 2D training image; and
processing the signed distance field image using the 2D encoder to generate the embedding.

4. The method of embodiment 1, comprising:

obtaining an initial input embedding that encodes a representation of a target three-dimensional (3D) object;
processing the initial input embedding using a sub-embedding decoder of a 3D autoencoder to obtain sub-embeddings including the input embedding, wherein the sub-embeddings encode 2D shapes that define the representation of the target 3D object;
generating parametric sketch models, comprising:

processing each of the sub-embeddings using one or more intermediate 2D decoders to obtain the 2D shapes that define the representation of the target 3D object;
generating each of intermediate embeddings by processing each of the 2D shapes using the 2D encoder of the 2D autoencoder; and
performing the determining a respective parametric sketch model of the parametric sketch models for each of the intermediate embeddings, wherein the respective parametric sketch model is the fitted 2D parametric sketch model, wherein the decoded representation of the target 2D shape is each of the 2D shapes;

generating a set of extrusion parameters from the sub-embeddings; and
generating a 3D boundary representation (B-Rep) model of the target 3D object, wherein the generating comprises using the fitted 2D parametric sketch models in a construction sequence to construct the 3D B-Rep model through extrusion into a 3D space, wherein the construction sequence comprises the set of extrusion parameters.

5. The method of embodiment 4, wherein the sub-embedding decoder comprises a multi-layer perceptron (MLP).

6. The method of embodiment 4, wherein the one or more intermediate 2D decoders include the 2D decoder of the 2D autoencoder.

7. The method of embodiment 4, wherein the one or more intermediate 2D decoders include a second 2D decoder that is different from the 2D decoder of the 2D autoencoder.

8. The method of embodiment 4, wherein the 3D autoencoder comprises:

a 3D encoder that processes an input voxel model to generate a 3D object embedding,
the sub-embedding decoder that processes the 3D object embedding to generate the sub-embeddings,
a start envelope decoder that processes each sub-embedding of the sub-embeddings to generate a start envelope function,
an end envelope decoder that processes each sub-embedding of the sub-embeddings to generate an end envelope function, wherein the set of extrusion parameters are generated from the start envelope function and the end envelope function, and
a differentiable Boolean engine that generates a reconstructed model by extruding the 2D shapes into the 3D space using the start envelope function and the end envelope functions.

9. The method of embodiment 8, comprising:

obtaining training examples, wherein each training example comprises a training voxel model, a ground truth voxel model, and ground truth 2D shapes, wherein the ground truth voxel model is defined by the ground truth 2D shapes extruded into a 3D space using a set of ground truth extrusion parameters that defines a ground truth envelope function, wherein the training voxel model is generated from the ground truth voxel model; and
training the 3D autoencoder on the training examples, comprising:
for each of the training examples:

processing the training voxel model using the 3D encoder to generate the 3D object embedding of the training voxel model; and
processing the 3D object embedding using the sub-embedding decoder to generate the sub-embeddings;
processing each sub-embedding of the sub-embeddings using the 2D decoder to generate a 2D shape of the 2D shapes;
processing each sub-embedding of the sub-embeddings using the start envelope decoder to generate a start envelope function of the 2D shape;
processing each sub-embedding of the sub-embeddings using the end envelope decoder to generate an end envelope function of the 2D shape; and
generating a reconstructed voxel model of the training voxel model by using the 2D shapes in a predicted construction sequence to construct the reconstructed voxel model through expansion in the 3D space, wherein the predicted construction sequence comprises operations defined in the differentiable Boolean engine and the start envelope function and the end envelope function of each of the 2D shapes;
computing a value of a first loss function by comparing each training voxel model with its corresponding reconstructed voxel model; and
updating parameters of the 3D autoencoder based at least on the value of the first loss function.

10. The method of embodiment 9, further comprising:

computing a value of a second loss function by comparing the ground truth 2D shapes with the 2D shapes and by comparing the start envelope function and the end envelope function with the ground truth envelope function; and

updating the parameters of the 3D autoencoder based at least on the value of the first loss function and the value of the second loss function.

11. The method of embodiment 9, wherein the training voxel model is generated from the ground truth voxel model through a morphological modification.

12. The method of embodiment 8, wherein the 3D autoencoder comprises decoding modules and each of the decoding modules corresponds to a different predefined set of one or more extrusion directions and a different predefined one or more Boolean operations, wherein each of the decoding modules comprises a respective sub-embedding decoder, a respective start envelope decoder, and a respective end envelope decoder.

13. The method of embodiment 4, wherein obtaining the initial input embedding comprises:

generating a first 3D object embedding from a first voxel model of a first 3D obj ect;
generating a second 3D object embedding from a second voxel model of a second 3D object; and
generating the initial input embedding from the first 3D object embedding and the second 3D object embedding.

14. The method of embodiment 4, comprising:

obtaining an initial voxel model of the target 3D object;
generating a modified voxel model by processing the initial voxel model through a morphological modification;
generating the initial input embedding by processing the modified voxel model using a 3D encoder included in the 3D autoencoder; and
generating a reconstructed 3D B-Rep model from the fitted 2D parametric sketch models using the construction sequence through the extrusion into the 3D space, wherein the reconstructed 3D B-Rep model is similar to the initial voxel model.

15. The method of embodiment 4, comprising:

obtaining an initial voxel model of the target 3D object, wherein the initial voxel model is generated from a generative design output;
generating the initial input embedding by processing the initial voxel model using a 3D encoder included in the 3D autoencoder; and
generating a 3D prismatic model of the target 3D object, wherein the 3D prismatic model of the target 3D object is the 3D B-Rep model.

16. The method of embodiment 4, further comprising:

obtaining an initial voxel model of the target 3D object, wherein the initial voxel model is generated from a generative design output;
generating the initial input embedding by processing the initial voxel model using a 3D encoder included in the 3D autoencoder; and
fitting the 3D B-Rep model to the initial voxel model of the target 3D object by changing one or more parameters of the 3D B-Rep model to produce a fitted 3D B-Rep model.

17. The method of embodiment 1, wherein the using the fitted 2D parametric sketch model comprises: displaying the fitted 2D parametric sketch model in a user interface of the computer modeling program.

18. The method of embodiment 1, comprising:

obtaining an input 2D image, wherein the input 2D image includes two or more 2D shapes;
generating sub-image portions from the input 2D image, wherein each sub-image portion depicts a 2D shape of the two or more 2D shapes;
generating a respective sub-image portion embedding for each sub-image portion of the sub-image portions;
determining fitted 2D parametric sketch models, comprising: performing the determining each fitted 2D parametric sketch model for each sub-image portion embedding; and
generating a combined 2D parametric sketch model by combining the fitted 2D parametric sketch models at respective locations of the sub-image portions.

19. A system comprising:

a non-transitory storage medium having instructions of a computer aided design program stored thereon; and one or more data processing apparatus configured to run the instructions of the computer aided design program to perform operations specified by the instructions of the computer aided design program; wherein the operations comprise

obtaining an input embedding that encodes a representation of a target two-dimensional (2D) shape; processing the input embedding using a 2D decoder of a 2D autoencoder to obtain a decoded representation of the target 2D shape, wherein the 2D autoencoder comprises a 2D encoder that processes a representation of a 2D object to generate an object embedding, and the 2D decoder that processes the object embedding to generate the decoded representation of the 2D object; determining a fitted 2D parametric sketch model for the input embedding, comprising:

finding a 2D parametric sketch model for the input embedding using a search in an embedding space of the 2D autoencoder and a database of sketch models associated with the 2D autoencoder, wherein a shape of the 2D parametric sketch model is determined by one or more parameter values of the 2D parametric sketch model; and fitting the 2D parametric sketch model to the decoded representation of the target 2D shape by modifying the one or more parameter values of the 2D parametric sketch model to produce the fitted 2D parametric sketch model; and

using the fitted 2D parametric sketch model in a computer modeling program.

20. The system of embodiment 19, wherein the operations comprise:

obtaining parameterized instantiations of 2D parametric sketch models; generating 2D training images from the parameterized instantiations of the 2D parametric sketch models, wherein each of the 2D training images corresponds to a parameterized instantiation of a 2D parametric sketch model; and training the 2D autoencoder on the 2D training images, comprising: for each of the 2D training images:

processing the 2D training image using the 2D encoder to generate an embedding; and processing the embedding using the 2D decoder to generate a decoded 2D image; computing a value of a loss function by comparing each of the 2D training images with its corresponding decoded 2D image; and

updating parameters of the 2D encoder and parameters of the 2D decoder based on the value of the loss function.

21. The system of embodiment 19, wherein the operations comprise:

obtaining an initial input embedding that encodes a representation of a target three-dimensional (3D) object; processing the initial input embedding using a sub-embedding decoder of a 3D autoencoder to obtain sub-embeddings including the input embedding, wherein the sub-embeddings encode 2D shapes that define the representation of the target 3D object; generating parametric sketch models, comprising:

processing each of the sub-embeddings using one or more intermediate 2D decoders to obtain the 2D shapes that define the representation of the target 3D object; generating each of intermediate embeddings by processing each of the 2D shapes using the 2D encoder of the 2D autoencoder; and performing the determining a respective parametric sketch model of the parametric sketch models for each of the intermediate embeddings, wherein the respective parametric sketch model is the fitted 2D parametric sketch model, wherein the decoded representation of the target 2D shape is each of the 2D shapes;

generating a set of extrusion parameters from the sub-embeddings; and generating a 3D boundary representation (B-Rep) model of the target 3D object, wherein the generating comprises using the fitted 2D parametric sketch models in a construction sequence to construct the 3D B-Rep model through extrusion into a 3D space, wherein the construction sequence comprises the set of extrusion parameters.

22. The system of embodiment 21, wherein the 3D autoencoder comprises:

a 3D encoder that processes an input voxel model to generate a 3D object embedding,
the sub-embedding decoder that processes the 3D object embedding to generate the sub-embeddings,
a start envelope decoder that processes each sub-embedding of the sub-embeddings to generate a start envelope function,
an end envelope decoder that processes each sub-embedding of the sub-embeddings to generate an end envelope function, wherein the set of extrusion parameters are generated from the start envelope function and the end envelope function, and
a differentiable Boolean engine that generates a reconstructed model by extruding the 2D shapes into the 3D space using the start envelope function and the end envelope functions;
and wherein the operations comprise:

obtaining training examples, wherein each training example comprises a training voxel model, a ground truth voxel model, and ground truth 2D shapes, wherein the ground truth voxel model is defined by the ground truth 2D shapes extruded into a 3D space using a set of ground truth extrusion parameters that defines a ground truth envelope function, wherein the training voxel model is generated from the ground truth voxel model; and
training the 3D autoencoder on the training examples, comprising:
for each of the training examples:

processing the training voxel model using the 3D encoder to generate the 3D object embedding of the training voxel model; and
processing the 3D object embedding using the sub-embedding decoder to generate the sub-embeddings;
processing each sub-embedding of the sub-embeddings using the 2D decoder to generate a 2D shape of the 2D shapes;
processing each sub-embedding of the sub-embeddings using the start envelope decoder to generate a start envelope function of the 2D shape;
processing each sub-embedding of the sub-embeddings using the end envelope decoder to generate an end envelope function of the 2D shape; and
generating a reconstructed voxel model of the training voxel model by using the 2D shapes in a predicted construction sequence to construct the reconstructed voxel model through expansion in the 3D space, wherein the predicted construction sequence comprises operations defined in the differentiable Boolean engine and the start envelope function and the end envelope function of each of the 2D shapes;
computing a value of a first loss function by comparing each training voxel model with its corresponding reconstructed voxel model; and
updating parameters of the 3D autoencoder based at least on the value of the first loss function.

23. A non-transitory computer-readable medium encoding instructions operable to cause data processing apparatus to perform operations comprising:

obtaining an input embedding that encodes a representation of a target two-dimensional (2D) shape;
processing the input embedding using a 2D decoder of a 2D autoencoder to obtain a decoded representation of the target 2D shape, wherein the 2D autoencoder comprises a 2D encoder that processes a representation of a 2D object to generate an object embedding, and the 2D decoder that processes the object embedding to generate the decoded representation of the 2D object;
determining a fitted 2D parametric sketch model for the input embedding, comprising:

finding a 2D parametric sketch model for the input embedding using a search in an embedding space of the 2D autoencoder and a database of sketch models associated with the 2D autoencoder, wherein a shape of the 2D parametric sketch model is determined by one or more parameter values of the 2D parametric sketch model; and
fitting the 2D parametric sketch model to the decoded representation of the target 2D shape by modifying the one or more parameter values of the 2D parametric sketch model to produce the fitted 2D parametric sketch model; and

using the fitted 2D parametric sketch model in a computer modeling program.

24. The non-transitory computer-readable medium of embodiment 23, wherein the operations comprise:

obtaining parameterized instantiations of 2D parametric sketch models;
generating 2D training images from the parameterized instantiations of the 2D parametric sketch models, wherein each of the 2D training images corresponds to a parameterized instantiation of a 2D parametric sketch model; and
training the 2D autoencoder on the 2D training images, comprising:
for each of the 2D training images:

processing the 2D training image using the 2D encoder to generate an embedding; and
processing the embedding using the 2D decoder to generate a decoded 2D image;
computing a value of a loss function by comparing each of the 2D training images with its corresponding decoded 2D image; and

updating parameters of the 2D encoder and parameters of the 2D decoder based on the value of the loss function.

25. The non-transitory computer-readable medium of embodiment 23, wherein the operations comprise:

obtaining an initial input embedding that encodes a representation of a target three-dimensional (3D) object;
processing the initial input embedding using a sub-embedding decoder of a 3D autoencoder to obtain sub-embeddings including the input embedding, wherein the sub-embeddings encode 2D shapes that define the representation of the target 3D object;
generating parametric sketch models, comprising:

processing each of the sub-embeddings using one or more intermediate 2D decoders to obtain the 2D shapes that define the representation of the target 3D object;
generating each of intermediate embeddings by processing each of the 2D shapes using the 2D encoder of the 2D autoencoder; and
performing the determining a respective parametric sketch model of the parametric sketch models for each of the intermediate embeddings, wherein the respective parametric sketch model is the fitted 2D parametric sketch model, wherein the decoded representation of the target 2D shape is each of the 2D shapes;

generating a set of extrusion parameters from the sub-embeddings; and
generating a 3D boundary representation (B-Rep) model of the target 3D object, wherein the generating comprises using the fitted 2D parametric sketch models in a construction sequence to construct the 3D B-Rep model through extrusion into a 3D space, wherein the construction sequence comprises the set of extrusion parameters.

## Claims

1. A method comprising:

obtaining an input embedding that encodes a representation of a target two-dimensional (2D) shape;
processing the input embedding using a 2D decoder of a 2D autoencoder to obtain a decoded representation of the target 2D shape, wherein the 2D autoencoder comprises a 2D encoder that processes a representation of a 2D object to generate an object embedding, and the 2D decoder that processes the object embedding to generate the decoded representation of the 2D object;
determining a fitted 2D parametric sketch model for the input embedding, comprising:

finding a 2D parametric sketch model for the input embedding using a search in an embedding space of the 2D autoencoder and a database of sketch models associated with the 2D autoencoder, wherein a shape of the 2D parametric sketch model is determined by one or more parameter values of the 2D parametric sketch model; and
fitting the 2D parametric sketch model to the decoded representation of the target 2D shape by modifying the one or more parameter values of the 2D parametric sketch model to produce the fitted 2D parametric sketch model; and

using the fitted 2D parametric sketch model in a computer modeling program.

2. The method of claim 1, comprising:

obtaining parameterized instantiations of 2D parametric sketch models;
generating 2D training images from the parameterized instantiations of the 2D parametric sketch models, wherein each of the 2D training images corresponds to a parameterized instantiation of a 2D parametric sketch model; and
training the 2D autoencoder on the 2D training images, comprising:
for each of the 2D training images:

processing the 2D training image using the 2D encoder to generate an embedding; and
processing the embedding using the 2D decoder to generate a decoded 2D image;
computing a value of a loss function by comparing each of the 2D training images with its corresponding decoded 2D image; and
updating parameters of the 2D encoder and parameters of the 2D decoder based on the value of the loss function, wherein the training the 2D autoencoder on the 2D training images optionally comprises:

generating a signed distance field image from the 2D training image; and
processing the signed distance field image using the 2D encoder to generate the embedding.

3. The method of claim 1, comprising:

obtaining an initial input embedding that encodes a representation of a target three-dimensional (3D) object;
processing the initial input embedding using a sub-embedding decoder of a 3D autoencoder to obtain sub-embeddings including the input embedding, wherein the sub-embeddings encode 2D shapes that define the representation of the target 3D object, wherein optionally the sub-embedding decoder comprises a multi-layer perceptron, MLP;
generating parametric sketch models, comprising:

processing each of the sub-embeddings using one or more intermediate 2D decoders to obtain the 2D shapes that define the representation of the target 3D object;
generating each of intermediate embeddings by processing each of the 2D shapes using the 2D encoder of the 2D autoencoder; and
performing the determining a respective parametric sketch model of the parametric sketch models for each of the intermediate embeddings, wherein the respective parametric sketch model is the fitted 2D parametric sketch model, wherein the decoded representation of the target 2D shape is each of the 2D shapes;

generating a set of extrusion parameters from the sub-embeddings; and
generating a 3D boundary representation (B-Rep) model of the target 3D object, wherein the generating comprises using the fitted 2D parametric sketch models in a construction sequence to construct the 3D B-Rep model through extrusion into a 3D space, wherein the construction sequence comprises the set of extrusion parameters.

4. The method of claim 3, wherein the one or more intermediate 2D decoders include the 2D decoder of the 2D autoencoder, and wherein optionally the one or more intermediate 2D decoders include a second 2D decoder that is different from the 2D decoder of the 2D autoencoder.

5. The method of claim 3, wherein the 3D autoencoder comprises:

a 3D encoder that processes an input voxel model to generate a 3D object embedding,
the sub-embedding decoder that processes the 3D object embedding to generate the sub-embeddings,
a start envelope decoder that processes each sub-embedding of the sub-embeddings to generate a start envelope function,
an end envelope decoder that processes each sub-embedding of the sub-embeddings to generate an end envelope function, wherein the set of extrusion parameters are generated from the start envelope function and the end envelope function, and
a differentiable Boolean engine that generates a reconstructed model by extruding the 2D shapes into the 3D space using the start envelope function and the end envelope functions.

**6.** The method of claim 5, comprising:

obtaining training examples, wherein each training example comprises a training voxel model, a ground truth voxel model, and ground truth 2D shapes, wherein the ground truth voxel model is defined by the ground truth 2D shapes extruded into a 3D space using a set of ground truth extrusion parameters that defines a ground truth envelope function, wherein the training voxel model is generated from the ground truth voxel model, wherein optionally the training voxel model is generated from the ground truth voxel model through a morphological modification; and

training the 3D autoencoder on the training examples, comprising:
for each of the training examples:

processing the training voxel model using the 3D encoder to generate the 3D object embedding of the training voxel model; and

processing the 3D object embedding using the sub-embedding decoder to generate the sub-embeddings;

processing each sub-embedding of the sub-embeddings using the 2D decoder to generate a 2D shape of the 2D shapes;

processing each sub-embedding of the sub-embeddings using the start envelope decoder to generate a start envelope function of the 2D shape;

processing each sub-embedding of the sub-embeddings using the end envelope decoder to generate an end envelope function of the 2D shape; and

generating a reconstructed voxel model of the training voxel model by using the 2D shapes in a predicted construction sequence to construct the reconstructed voxel model through expansion in the 3D space, wherein the predicted construction sequence comprises operations defined in the differentiable Boolean engine and the start envelope function and the end envelope function of each of the 2D shapes;

computing a value of a first loss function by comparing each training voxel model with its corresponding reconstructed voxel model; and

updating parameters of the 3D autoencoder based at least on the value of the first loss function.

**7.** The method of claim 6, further comprising:

computing a value of a second loss function by comparing the ground truth 2D shapes with the 2D shapes and by comparing the start envelope function and the end envelope function with the ground truth envelope function; and

updating the parameters of the 3D autoencoder based at least on the value of the first loss function and the value of the second loss function.

**8.** The method of claim 5, wherein the 3D autoencoder comprises decoding modules and each of the decoding modules corresponds to a different predefined set of one or more extrusion directions and a different predefined one or more Boolean operations, wherein each of the decoding modules comprises a respective sub-embedding decoder, a respective start envelope decoder, and a respective end envelope decoder.

**9.** The method of claim 3, wherein obtaining the initial input embedding comprises:

generating a first 3D object embedding from a first voxel model of a first 3D obj ect;

generating a second 3D object embedding from a second voxel model of a second 3D object; and

generating the initial input embedding from the first 3D object embedding and the second 3D object embedding.

**10.** The method of claim 3, comprising:

obtaining an initial voxel model of the target 3D object;

generating a modified voxel model by processing the initial voxel model through a morphological modification;

generating the initial input embedding by processing the modified voxel model using a 3D encoder included in the 3D autoencoder; and

generating a reconstructed 3D B-Rep model from the fitted 2D parametric sketch models using the construction sequence through the extrusion into the 3D space, wherein the reconstructed 3D B-Rep model is similar to the initial voxel model.

**11.** The method of claim 3, comprising:

obtaining an initial voxel model of the target 3D object, wherein the initial voxel model is generated from a generative design output;

generating the initial input embedding by processing the initial voxel model using a 3D encoder included in the 3D autoencoder; and

generating a 3D prismatic model of the target 3D object, wherein the 3D prismatic model of the target 3D object is the 3D B-Rep model.

12. The method of claim 3, further comprising:

obtaining an initial voxel model of the target 3D object, wherein the initial voxel model is generated from a generative design output;

generating the initial input embedding by processing the initial voxel model using a 3D encoder included in the 3D autoencoder; and

fitting the 3D B-Rep model to the initial voxel model of the target 3D object by changing one or more parameters of the 3D B-Rep model to produce a fitted 3D B-Rep model.

13. The method of any one of the previous claims, comprising:

obtaining an input 2D image, wherein the input 2D image includes two or more 2D shapes;

generating sub-image portions from the input 2D image, wherein each sub-image portion depicts a 2D shape of the two or more 2D shapes;

generating a respective sub-image portion embedding for each sub-image portion of the sub-image portions;

determining fitted 2D parametric sketch models, comprising: performing the determining each fitted 2D parametric sketch model for each sub-image portion embedding; and

generating a combined 2D parametric sketch model by combining the fitted 2D parametric sketch models at respective locations of the sub-image portions.

14. A system comprising:

a non-transitory storage medium having instructions of a computer aided design program stored thereon; and

one or more data processing apparatus configured to run the instructions of the computer aided design program to perform operations according to the method of any one of claims 1 to 13.

15. A non-transitory computer-readable medium encoding instructions operable to cause data processing apparatus to perform operations according to the method of any one of claims 1 to 13.

*100*

*120* *122*

*133*

*132* *133(a)* *135*

*133(b)*

*133(c)*

Remote Computer
Systems
(e.g., Third Party
Providers)
*150*        *116*

Computer                *110*

CAD Program(s)
*116*

Machine
Learning
Algorithm
*134*

Sketch
Database
*130*

*140*

Network

Memory
*114*

3D Model
(e.g., B-Rep
Model)  *160*

Toolpaths

*165*

CNC Machine
(e.g. SM Machine)
*170*

Processor
*112*

*118*

*120a*

*190*

*174*

*118a*

*136*

*FIG. 1*

FIG. 2A

```
                                                    ┌── 232
┌─────────────────────────────────────────────┐
│  Obtain an initial input embedding that encodes a │
│    representation of a target 3D object          │
└─────────────────────────────────────────────┘
                      │
                      ▼              ┌── 234
┌─────────────────────────────────────────────┐
│  Process the initial input embedding using a sub- │
│  embedding decoder of a 3D autoencoder to obtain │
│  sub-embeddings, wherein the sub-embeddings encode │
│  2D shapes that define the representation of the target │
│                  3D object                       │
└─────────────────────────────────────────────┘
                      │
                      ▼              ┌── 236
┌─────────────────────────────────────────────┐
│  Determine parametric sketch models, including:  │
│  determining a respective parametric sketch model of │
│  the parametric sketch models for each of the sub- │
│  embeddings, wherein the respective parametric sketch │
│    model is a fitted 2D parametric sketch model  │
└─────────────────────────────────────────────┘
                      │
                      ▼              ┌── 237
┌─────────────────────────────────────────────┐
│  Generate a set of extrusion parameters from the sub- │
│                  embeddings                      │
└─────────────────────────────────────────────┘
                      │
                      ▼              ┌── 238
        Yes        ◇ User rejects the design? ◇
                      │
                      │ No
                      ▼              ┌── 240
┌─────────────────────────────────────────────┐
│  Generate a 3D B-Rep model of the target 3D object, │
│  wherein the generating includes using the fitted 2D │
│  parametric sketch models in a construction sequence │
│  to construct the 3D B-Rep model through extrusion into │
│  a 3D space, wherein the construction sequence   │
│    includes the set of extrusion parameters      │
└─────────────────────────────────────────────┘
```

*FIG. 2B*

*FIG. 3*

306

304

2D Decoder

302

Search in embedding space — 310

308 — Sketch Models Database

314 — Fitting

312

318 320

316

322 — Obtain an input embedding that encodes a representation of a target 2D shape

324 — Process the input embedding using a 2D decoder of a 2D autoencoder to obtain a decoded representation of the target 2D shape

326 — Find a 2D parametric sketch model for the input embedding using a search in an embedding space of the 2D autoencoder and a database of sketch models associated with the 2D autoencoder

328 — Fitting the 2D parametric sketch model to the decoded representation of the target 2D shape by modifying one or more parameter values of the 2D parametric sketch model to produce fitted 2D parametric sketch model

330 — Using the fitted 2D parametric sketch model in a computer modeling program

**422**
Obtain parameterized instantiations of 2D parametric sketch models

**424**
Generate 2D training images from the parameterized instantiations of the 2D parametric sketch models

**426**
For each of the 2D training images, process the 2D training image using the 2D encoder to generate an embedding

**428**
Process the embedding using the 2D decoder to generate a decoded 2D image

**430**
Compute a value of a loss function by comparing each of the 2D training images with its corresponding decoded 2D image

**432**
Update parameters of the 2D encoder and parameters of 2D decoder based on the value of the loss function

**434**
No — Determine whether the training is completed

Yes **436**
Use the 2D encoder and the 2D decoder

**402**

**406**

**420**
Loss Function

**408**
Signed Distance Function

**410**

**412**
2D Encoder

**414**

**416**
2D Decoder

**418**

*FIG. 4*

FIG. 5

602

Obtain training examples, wherein each training example includes a training voxel model, a ground truth voxel model, and ground truth 2D shapes, wherein the ground truth voxel model is defined by the ground truth 2D shapes extruded into a 3D space using a set of ground truth extrusion parameters that defines a ground truth envelope function, wherein the training voxel model is generated from the ground truth voxel model

604

For each of the training examples, process the training voxel model using the 3D encoder to generate the 3D object embedding of the training voxel model

606

Process the embedding using the sub-embedding decoder to generate the sub-embeddings

608

Process each sub-embedding of the sub-embeddings to generate a 2D shape of 2D shapes and start and end envelope functions

610

Generate a reconstructed voxel model of the training voxel model by using the 2D shapes in a predicted construction sequence to construct the reconstructed voxel model through the extrusion in the 3D space, wherein the predicted construction sequence includes operations defined in the differentiable Boolean engine and the start and end envelope functions

612

Compute a value of a first loss function by comparing each training voxel model with its corresponding reconstructed voxel model

614

Compute a value of a second loss function by comparing the ground truth 2D shapes with the 2D shapes and by comparing the start envelope function and the end envelope function with the ground truth envelope function

616

Update the parameters of the 3D autoencoder based at least on the value of the first loss function and the value of the second loss function

618

No

Determine whether the training is completed

Yes    620

Use the 3D autoencoder

FIG. 6

*FIG. 7*

FIG. 8A

FIG. 8B

**900**

## Data Processing Apparatus

**Applications** **904**

3D Modeling Program(s), e.g., CAD Program(s) that generates prismatic CAD models by machine learning

**Operating System**

**Hardware/Firmware**

**916**

Computer Readable Medium

**912**

Processor(s)

**918**

Comm. Interface

**914**

Additional Device(s)

**920**

User Interface Device(s)

**990**

**Network**

**980**

*FIG. 9*

Europäisches
Patentamt

European
Patent Office

Office européen
des brevets

# EUROPEAN SEARCH REPORT

Application Number

EP 23 16 3459

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 958 162 A1 (DASSAULT SYSTEMES [FR]) 23 February 2022 (2022-02-23) * abstract * * paragraphs [0046] – [0048] * * paragraphs [0068] – [0075] * * paragraphs [0076] – [0083] * * paragraph [0126]; figure 8 * ----- | 1–15 | INV. G06T17/10 G06F30/10 |
| X | MIKAELA ANGELINA UY ET AL: "Point2Cyl: Reverse Engineering 3D Objects from Point Clouds to Extrusion Cylinders", ARXIV.ORG, CORNELL UNIVERSITY LIBRARY, 201 OLIN LIBRARY CORNELL UNIVERSITY ITHACA, NY 14853, 17 December 2021 (2021-12-17), XP091119276, * section 4, in particular "Inferring sketches" of subsection 4.1 * * abstract; figure A6 * ----- | 1–15 | |
| X | ARI SEFF ET AL: "Vitruvion: A Generative Model of Parametric CAD Sketches", ARXIV.ORG, CORNELL UNIVERSITY LIBRARY, 201 OLIN LIBRARY CORNELL UNIVERSITY ITHACA, NY 14853, 28 April 2022 (2022-04-28), XP091194940, * section 3 * ----- | 1–15 | TECHNICAL FIELDS SEARCHED (IPC) G06T |

The present search report has been drawn up for all claims

| Place of search | Date of completion of the search | Examiner |
|---|---|---|
| Berlin | 16 October 2023 | Bouchaâla, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 3459

This annex lists the patent family members relating to the patent documents cited in the above-mentioned European search report.
The members are as contained in the European Patent Office EDP file on
The European Patent Office is in no way liable for these particulars which are merely given for the purpose of information.

16-10-2023

| Patent document cited in search report | | Publication date | Patent family member(s) | | Publication date |
|---|---|---|---|---|---|
| EP 3958162 | A1 | 23-02-2022 | CN | 114078182 A | 22-02-2022 |
| | | | EP | 3958162 A1 | 23-02-2022 |
| | | | JP | 2022036024 A | 04-03-2022 |
| | | | US | 2022058866 A1 | 24-02-2022 |

EPO FORM P0459

For more details about this annex : see Official Journal of the European Patent Office, No. 12/82

**EP 4 280 162 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **QI, CHARLES R. et al.** Pointnet: Deep learning on point sets for 3d classification and segmentation. *Proceedings of the IEEE conference on computer vision and pattern recognition,* 2017
- **WU, RUNDI ; CHANG XIAO ; CHANGXI ZHENG.** Deepcad: A deep generative network for computer-aided design models. *Proceedings of the IEEE/CVF International Conference on Computer Vision.,* 2021
- **KARL D. D. WILLIS ; PRADEEP KUMAR JAYARAMAN ; JOSEPH G. LAMBOURNE ; HANG CHU ; YEWEN PU.** Engineering Sketch Generation for Computer-Aided Design. *The 1st Workshop on Sketch-Oriented Deep Learning (SketchDL), CVPR,* 2021
- **GANIN, YAROSLAV et al.** Computer-aided design as language. *Advances in Neural Information Processing Systems,* 2021, vol. 34
- **PARA, WAMIQ et al.** Sketchgen: Generating constrained cad sketches. *Advances in Neural Information Processing Systems,* 2021, vol. 34
- **SEFF, ARI et al.** Vitruvion: A Generative Model of Parametric CAD Sketches. *arXiv:2109.14124,* 2021